# EUROPÄISCHE PATENTSCHRIFT

(11) **EP 1 476 452 B1**
(45) Veröffentlichungstag und Bekanntmachung des Hinweises auf die Patenterteilung: **20.07.2011**
(21) Anmeldenummer: 03706419.3
(22) Anmeldetag: 04.02.2003
(51) Int. Cl.: C07F 9/50, C07F 9/52

(54) **ACYL-UND BISACYLPHOSPHINDERIVATE**
ACYL- AND BISACYLPHOSPHINE DERIVATIVES
DERIVES D'ACYLPHOSPHINE ET DE BISACYLPHOSPHINE

(30) Priorität: 13.02.2002 DE 10206117
(43) Veröffentlichungstag der Anmeldung: 17.11.2004
(73) Patentinhaber: BASF SE, 67056 Ludwigshafen (DE)
(72) Erfinder: NOE, Ralf, 68163 Mannheim (DE); HENNE, Andreas, 67433 Neustadt (DE); MAASE, Matthias, 67346 Speyer (DE)
(86) Internationale Anmeldenummer: PCT/EP2003/001053
(87) Internationale Veröffentlichungsnummer: WO 2003/068784

(56) Entgegenhaltungen:
- EP-A- 0 007 508
- EP-A- 0 615 980
- US-A- 5 472 992
- US-B1- 6 207 727
- DATABASE CHEMABS [Online] CHEMICAL ABSTRACTS SERVICE, COLUMBUS, OHIO, US; SAL'KEEVA, L. K. ET AL: "Reactions of esters, thio esters, and amides of phosphorus(III) acids wit acyl halides" XP002236998 accession no. STN Database accession no. 118:39028 & ZHURNAL OBSHCHEI KHIMII (1992), 62(2), 333-8,
- DATABASE CHEMABS [Online] CHEMICAL ABSTRACTS SERVICE, COLUMBUS, OHIO, US; VEITS, YU. A. ET AL: "Reaction of secondary phosphines with carbon tetrachloride. Synthesis of acylalkylchlorophosphines" XP002236999 accession no. STN Database accession no. 115:92392 & ZHURNAL OBSHCHEI KHIMII (1991), 61(1), 130-5,
- DATABASE CHEMABS [Online] CHEMICAL ABSTRACTS SERVICE, COLUMBUS, OHIO, US; VEITS, YU. A. ET AL: "tert-Butylpivaloylphosphonous acid and its derivatives" XP002237000 accession no. STN Database accession no. 115:71748 & ZHURNAL OBSHCHEI KHIMII (1991), 61(1), 124-30,
- DATABASE CHEMABS [Online] CHEMICAL ABSTRACTS SERVICE, COLUMBUS, OHIO, US; VEITS, YU. A. ET AL: "Synthesis and properties of acyltrialkyldiphosphines" XP002237001 accession no. STN Database accession no. 114:62212 & ZHURNAL OBSHCHEI KHIMII (1990), 60(9), 2028-36,
- DATABASE CHEMABS [Online] CHEMICAL ABSTRACTS SERVICE, COLUMBUS, OHIO, US; GAZIZOV, T. K. ET AL: "Reaction of diethyl S-butyl thiophosphite with acyl chlorides" XP002237002 accession no. STN Database accession no. 112:179121 & ZHURNAL OBSHCHEI KHIMII (1989), 59(8), 1913-15,
- DATABASE CHEMABS [Online] CHEMICAL ABSTRACTS SERVICE, COLUMBUS, OHIO, US; SINYASHIN, O. G. ET AL: "Reaction of tert-butyl(ethylthio)phosphine with carboxylic acid chlorides" XP002237003 accession no. STN Database accession no. 111:78181 & ZHURNAL OBSHCHEI KHIMII (1988), 58(10), 2206-12,
- DATABASE CHEMABS [Online] CHEMICAL ABSTRACTS SERVICE, COLUMBUS, OHIO, US; KIM, T. V. ET AL: "Vinyl esters of phosphorus acids. XVI. Chemical properties of alkyl(alken-1-yl) chlorophosphites" XP002237004 accession no. STN Database accession no. 90:38497 & ZHURNAL OBSHCHEI KHIMII (1978), 48(9), 1967-73,
- DATABASE CHEMABS [Online] CHEMICAL ABSTRACTS SERVICE, COLUMBUS, OHIO, US; NOVITSKII, K. I. ET AL: "Reaction of.beta.,.gamma.-unsaturated acid chlorides with cyclic glycol chlorophosphites" XP002237005 accession no. STN Database accession no. 67:32743 & ZHURNAL OBSHCHEI KHIMII (1967), 37(2), 512,
- BOYD, E.A. ET AL.: "Facile synthesis of functionalised phenylphosphinic acid derivatives" TETRAHEDRON LETTERS, Bd. 37, Nr. 10, 1996, Seiten 1651-1654, XP002236997

## Beschreibung

Die vorliegende Erfindung betrifft reaktive Acyl- und Bisacylphosphinderivate, Verfahren zu deren Herstellung und deren Verwendung.

Acyl- und Bisacylphosphinoxide und deren Verwendung als Photoinitiatoren sind seit langem bekannt.

Aus JP 10-62927, JP 9-152689, EP-A 724 194 und JP 3-10241 sind Verbindungen mit einer Phosphinoxidstruktur bekannt, die am zentralen Phosphoratom eine Hydroxylamino- oder Alkoxylaminogruppe beziehungsweise Hydrazidogruppe tragen, die Verwendung in photographischen Materialien finden.

Aus US 5 683 615 sind magnetorheologische Flüssigkeiten bekannt, die Dialkyldithiophosphate enthalten.

Weiterhin bekannt sind Derivate von Acylphosphinoxiden, wie z.B. solche, die eine gegebenenfalls substituierte Aminogruppe, eine Hydroxygruppe oder eine Gruppierung -O-M⁺, wobei M⁺ ein Äquivalent eines Kations ist, am zentralen Phosphoratom tragen (EP-A 62 839), eine C₁ - C₁₂-Alkoxygruppe (DE-A 196 50 562), eine Aryloxygruppe (EP-A 600 373) oder eine Silyloxygruppe (EP-A 487 453), die ebenfalls als Photoinitiatoren verwendbar sind.

Problematisch an einer Vielzahl bisher verwendeter Photoinitiatoren ist, daß Reste oder Abbauprodukte von Photoinitiatoren aus der gehärteten Beschichtung heraus in das umgebende Medium diffundieren (Migration) und dort Probleme schaffen können, beispielsweise wenn es sich um Verpackungsmaterialien für Lebensmittel handelt.

Weiterhin ist die niedrige Löslichkeit sowie Einarbeitbarkeit bestimmter Phosphinoxide begrenzt, so daß weiterhin Bedarf an anderen Phosphinoxiden mit verbesserten Wechselwirkungen zum starhlungshärtbaren Lacksystem besteht.

In der radikalischen Photopolymerisation besteht immer noch ein Bedarf an hochreaktiven, leicht herstellbaren und leicht handhabbaren Photoinitiatorsystemen. Weiterhin sollten solche Systeme thermisch stabil und lagerstabil sein.

Bekannt ist die Synthese von Acylphosphinoxiden in einer Arbusov-Umlagerung durch Umsetzung von Alkoxyphosphinen und Säurechloriden aus der EP-B 7 508:

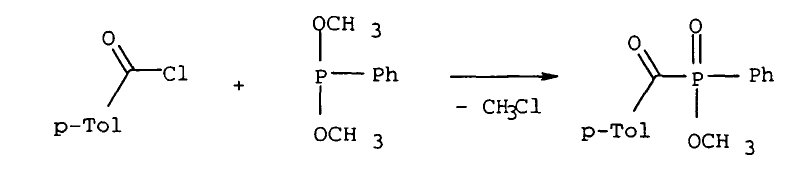

Darin bedeuten p-Tol = 4-Methylphenyl und Ph = Phenyl.

Aus US 5 472 992 ist die Synthese von Bisacylphosphinen bekannt, in der ein Phosphin in Gegenwart einer Base diacyliert und anschließend oxidert wird.

Nachteilig an diesen Synthesemethoden ist jedoch, daß flüchtige, giftige und übelriechende Phosphine verwendet werden müssen.

Aus der WO 00/32612 ist weiterhin die Synthese von Acyl- und Bisacylphosphinen bekannt, in der ein organisches Phosphorylhalogenid mit einem Alkalimetall oder Magnesium/Lithium in Kontakt gebracht wird und die dabei entstehenden metallierten Phosphine dann mit einem Säurechlorid umgesetzt werden:

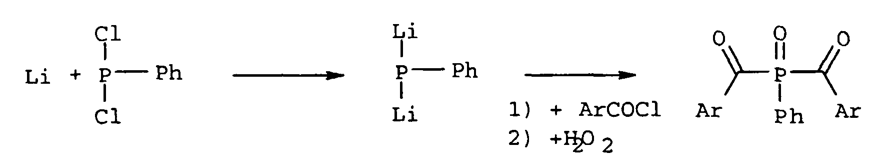

Darin bedeuten Ph = Phenyl und Ar = Aryl.

Eine solche Reaktion erfordert jedoch den aufwendigen Umgang mit z.B. metallischem Lithium für die Metallierung.

Diesen vorgestellten Synthesen ist gemein, daß sie von Ihren Substraten beschränkt sind und so die Produkte nur in engen Grenzen variiert werden können.

Aufgabe der vorliegenden Erfindung war es, Verbindungen bereitzustellen, die die einfache Synthese neuer Acyl- und Bisacylphosphinderivate mit hoher Toleranz gegenüber funktionellen Gruppen ermöglichen und selbst ebenfalls als möglichst wenig migrierende Photoinitiatoren eingesetzt werden können.

Die Aufgabe wurde gelöst durch Acyl- oder Bisacylphosphinderivat gemäß Formel (I) 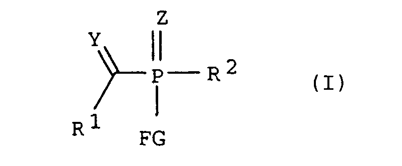 worin
R¹ Phenyl, Tolyl, Xylyl, α-Naphthyl, β-Naphthyl, 2- 3- oder 4-Chlorphenyl,2,6-oder2,4-Dichlorphenyl, 2,4,6-Trichlorphenyl, 2-, 3- oder 4-Methylphenyl, 2,6- oder 2,4-Dimethylphenyl, 2,4,6-Trimethylphenyl, 2-, 3- oder 4-Ethylphenyl, 2,6- oder 2,4-Diethylphenyl, 2-, 3- oder 4-*iso*-Propylphenyl, 2-, 3- oder 4-tert.-Butylphenyl, 2-, 3- oder 4-Methoxyphenyl, 2,6- oder 2,4-Dimethoxyphenyl, 2,6- oder 2,4-Diethoxyphenyl, Methylnaphthyl, 2,6-Dimethylphenyl, 2,4,6-Trimethylphenyl, 2,6-Dimethoxyphenyl, 2,6-Dichlorphenyl, 4-Bromphenyl, 2- oder 4-Nitrophenyl, 2,4- oder 2,6-Dinitrophenyl, 4-Dimethylaminophenyl, 4-Acetylphenyl, Cyclopentyl, Cyclohexyl, 2,5-Dimethylcyclopentyl, 2,6-Dimethylcyclohexyl, 2,6-Diethylcyclohexyl, 2,6-Dimethoxycyclohexyl, 2,6-Diethoxycyclohexyl, 2,6-Dichlorcyclohexyl, 2,5-Dichlorcyclopentyl, 2- oder 3-Furyl, 2- oder 3-Thiophenyl, 2- oder 3-Pyrryl, Dimethylpyrryl oder ortho-substituierte Phenyle, wie 2-Methylphenyl, 2-Methoxyphenyl oder 2-Chlorphenyl ist,
R², R⁵, R⁶, R⁷, C₁ - C₁₉-Alkyl, gegebenenfalls durch ein oder mehrere Sauerstoff- und/oder Schwefelatome und/oder ein oder mehrere substituierte oder unsubstituierte Iminogruppen unterbrochenes C₂-C₁₉-Alkyl, C₂-C₁₈-Alkenyl, C₆-C₁₂-Aryl, C₅-C₁₂-Cycloalkyl oder einen fünf- bis sechsgliedrigen, Sauerstoff-, Stickstoff- und/oder Schwefelatome aufweisenden Heterocyclus, wobei die genannten Reste jeweils durch Aryl, Alkyl, Aryloxy, Alkyloxy, Heteroatome und/oder Heterocyclen substituiert sein können,
- R²: ferner gegebenenfalls durch Aryl, Alkyl, Aryloxy, Alkyloxy, Heteroatome und/oder Heterocyclen substituiertes C₁-C₁₈-Alkoxy oder R¹-(C=Y)-,
- Y: O, S, NR³, N-OR³ oder N-NR³R⁴,
- Z: O, S, NR³, N-OR³, N-NR³R⁴ oder ein freies Elektronenpaar,
- R³: Wasserstoff, C₁ bis C₄-Alkyl, -SO₃H, Phenyl oder Acetyl,
- R⁴: Wasserstoff, C₁ bis C₄-Alkyl, COOR³, Arylsulfonyl oder gegebenenfalls durch Aryl, Alkyl, Aryloxy, Alkyloxy, Heteroatome und/oder Heterocyclen substituiertes C₅-C₁₂-Aryl,
- FG: eine Abgangsgruppe der Struktur-Cl, -CN, -OCN, -SCN, -N⁵R⁶R⁷R⁸, -O(CO)R⁵, -O(CO)OR⁵, -O(SO)Cl, -O(SO₂)R⁵ oder -O(CO)Cl,
- R⁵: ferner gegebenenfalls durch Aryl, Alkyl, Aryloxy, Alkyloxy, Heteroatome und/oder Heterocyclen substituiertes C₁-C₁₉-Alkoxy, sowie
- R⁰: gegebenenfalls durch Aryl, Alkyl, Aryloxy, Alkyloxy, Heteroatome und/oder Heterocyclen substituiertes C₁-C₁₈-Alkyl oder gegebenenfalls durch ein oder mehrere Sauerstoff- und/oder Schwefelatome und/oder ein oder mehrere substituierte oder unsubstituierte Iminogruppen unterbrochenes C₂ - C₁₈-Alkyl,
bedeuten.

Darin bedeuten
gegebenenfalls durch Aryl, Alkyl, Aryloxy, Alkyloxy, Heteroatome und/oder Heterocyclen substituiertes C₁ - C₁₈-Alkyl beispielsweise Methyl, Ethyl, Propyl, Isopropyl, n-Butyl, sec-Butyl, tert.-Butyl, Pentyl, Hexyl, Heptyl, Octyl, 2-Etylhexyl, 2,4,4-Trimethylpentyl, Decyl, Dodecyl, Tetradecyl, Hetadecyl, Octadecyl, 1,1-Dimethylpropyl, 1,1-Dimethylbutyl, 1,1,3,3-Tetramethylbutyl, Benzyl, 1-Phenylethyl, 2-Phenylethyl, α,α-Dimethylbenzyl, Benzhydryl, p-Tolylmethyl,1-(p-Butylphenyl)-ethyl, p-Chlorbenzyl, 2,4-Dichlorbenzyl, p-Methoxybenzyl, m-Ethoxybenzyl, 2-Cyanoethyl, 2-Cyanopropyl, 2-Methoxycarbonethyl, 2-Ethoxycarbonylethyl, 2-Butoxycarbonylpropyl, 1,2-Di-(methoxycarbonyl)-ethyl, 2-Methoxyethyl, 2-Ethoxyethyl, 2-Butoxyethyl, Diethoxymethyl, Diethoxyethyl, 1,3-Dioxolan-2-yl, 1,3-Dioxan-2-yl, 2-Methyl-1,3-dioxolan-2-yl, 4-Methyl-1,3-dioxolan-2-yl, 2-Isopropoxyethyl, 2-Butoxypropyl, 2-Octyloxyethyl, Chlormethyl, 2-Chlorethyl, Trichlormethyl, Trifluormethyl, 1,1-Dimethyl-2-chlorethyl, 2-Methoxyisopropyl, 2-Ethoxyethyl, Butylthiomethyl, 2-Dodecylthioethyl, 2-Phenylthioethyl, 2,2,2-Trifluorethyl, 2-Hydroxyethyl, 2-Hydroxypropyl, 3-Hydroxypropyl, 4-Hydroxybutyl, 6-Hydroxyhexyl, 2-Aminoethyl, 2-Aminopropyl, 3-Aminopropyl, 4-Aminobutyl, 6-Aminohexyl, 2-Methylaminoethyl, 2-Methylaminopropyl, 3-Methylaminopropyl, 4-Methylaminobutyl, 6-Methylaminohexyl, 2-Dimethylaminoethyl, 2-Dimethylaminopropyl, 3-Dimethylaminopropyl, 4-Dimethylaminobutyl, 6-Dimethylaminohexyl, 2-Hydroxy-2,2-dimethylethyl, 2-Phenoxyethyl, 2-Phenoxypropyl, 3-Phenoxypropyl, 4-Phenoxybutyl, 6-Phenoxyhexyl, 2-Methoxyethyl, 2-Methoxypropyl, 3-Methoxypropyl, 4-Methoxybutyl, 6-Methoxyhexyl, 2-Ethoxyethyl, 2-Ethoxypropyl, 3-Ethoxypropyl, 4-Ethoxybutyl oder 6-Ethoxyhexyl,
gegebenenfalls durch Aryl, Alkyl, Aryloxy, Alkyloxy, Heteroatome und/oder Heterocyclen substituiertes C₁ - C₁₈-Alkoxy beispielsweise Methoxy, Ethoxy, n-Propyloxy, iso-Propyloxy, n-Butyloxy, iso-Butyloxy, sek.-Butyloxy, tert.-Butyloxy, 6-Hydroxy-1,4-dioxohexyl, 9-Hydroxy-1,4,7-trioxononyl, 12-Hydroxy-1,4,7,10-tetraoxododecyl, 6-Methoxy-1,4-dioxohexyl, 9-Methoxy-1,4,7-trioxononyl, 12-Methoxy-1,4,7,10-tetraoxododecyl, 6-Ethoxy-1,4-dioxohexyl, 9-Ethoxy-1,4,7-trioxononyl, 12-Ethoxy-1,4,7,10-tetraoxododecyl, 8-Hydroxy-1,5-dioxooctyl, 12-Hydroxy-1,5,9-trioxooctyl, 16-Hydroxy-1,5,9,13-tetraoxohexadecyl, 8-Methoxy-1,5-dioxooctyl, 12-Methoxy-1,5,9-trioxooctyl, 16-Methoxy-1,5,9,13-tetraoxohexadecyl, 8-Ethoxy-1,5-dioxooctyl, 12-Ethoxy-1,5,9-trioxooctyl, 16-Ethoxy-1,5,9,13-tetraoxohexadecyl, 10-Hydroxy-1,6-dioxodecyl, 15-Hydroxy-1,6,11-trioxopentadecyl, 10-Methoxy-1,6-dioxodecyl, 15-Methoxy-1,6,11-trioxopentadecyl, 10-Ethoxy-1,6-dioxodecyl oder 15-Ethoxy-1,6,11-trioxopentadecyl,
gegebenenfalls durch ein oder mehrere Sauerstoff- und/oder Schwefelatome und/oder ein oder mehrere substituierte oder unsubstituierte Iminogruppen unterbrochenes C₂ - C₁₈-Alkyl beispielsweise 5-Hydroxy-3-oxa-pentyl, 8-Hydroxy-3,6-dioxa-octyl, 11-Hydroxy-3,6,9-trioxa-undecyl, 7-Hydroxy-4-oxa-heptyl, 11-Hydroxy-4,8-dioxa-undecyl, 15-Hydroxy-4,8,12-trioxa-pentadecyl, 9-Hydroxy-5-oxa-nonyl, 14-Hydroxy-5,10-oxa-tetradecyl, 5-Methoxy-3-oxa-pentyl, 8-Methoxy-3,6-dioxa-octyl, 11-Methoxy-3,6,9-trioxa-undecyl, 7-Methoxy-4-oxa-heptyl, 11-Methoxy-4,8-dioxa-undecyl, 15-Methoxy-4,8,12-trioxa-pentadecyl, 9-Methoxy-5-oxa-nonyl, 14-Methoxy-5,10-oxa-tetradecyl, 5-Ethoxy-3-oxa-pentyl, 8-Ethoxy-3,6-dioxa-octyl, 11-Ethoxy-3,6,9-trioxa-undecyl, 7-Ethoxy-4-oxa-heptyl, 11-Ethoxy-4,8-dioxa-undecyl, 15-Ethoxy-4,8,12-trioxa-pentadecyl, 9-Ethoxy-5-oxa-nonyl oder 14-Ethoxy-5,10-oxa-tetradecyl.

Die Anzahl der Sauerstoff- und/oder Schwefelatome und/oder Iminogruppen ist nicht beschränkt. In der Regel beträgt sie nicht mehr als 5 in dem Rest, bevorzugt nicht mehr als 4 und ganz besonders bevorzugt nicht mehr als 3.

Weiterhin befinden sich zwischen zwei Heteroatomen in der Regel mindestens ein Kohlenstoffatom, bevorzugt mindestens zwei.

Substituierte und unsubstituierte Iminogruppen können beispielsweise Imino-, Methylimino-, iso-Propylimino, n-Butylimino oder *tert*-Butylimino sein.

Weiterhin bedeutet
gegebenenfalls durch Aryl, Alkyl, Aryloxy, Alkyloxy, Heteroatome und/oder Heterocyclen substituiertes C₂ - C₁₈-Alkenyl beispielsweise Vinyl, 1-Propenyl, Allyl, Methallyl, 1,1-Dimethylallyl, 2-Butenyl, 2-Hexenyl, Octenyl, Undecenyl, Dodecenyl, Octadecenyl, 2-Phenylvinyl, 2-Methoxyvinyl, 2-Ethoxyvinyl, 2-Methoxyallyl, 3-Methoxyallyl, 2-Ethoxyallyl, 3-Ethoxyallyl oder 1- oder 2-Chlorvinyl, gegebenenfalls durch Aryl, Alkyl, Aryloxy, Alkyloxy, Heteroatome und/oder Heterocyclen substituiertes C₆ - C₁₂-Aryl beispielsweise Phenyl, Tolyl, Xylyl, α-Naphthyl, β-Naphthyl, 4-Diphenylyl, Chlorphenyl, Dichlorphenyl, Trichlorphenyl, Difluorphenyl, Methylphenyl, Dimethylphenyl, Trimethylphenyl, Ethylphenyl, Diethylphenyl, iso-Propylphenyl, tert.-Butylphenyl, Dodecylphenyl, Methoxyphenyl, Dimethoxyphenyl, Ethoxyphenyl, Hexyloxyphenyl, Methylnaphthyl, Isopropylnaphthyl, Chlornaphthyl, Ethoxynaphthyl, 2,6-Dimethylphenyl, 2,4,6-Trimethylphenyl, 2,6-Dimethoxyphenyl, 2,6-Dichlorphenyl, 4-Bromphenyl, 2- oder 4-Nitrophenyl, 2,4- oder 2,6-Dinitrophenyl, 4-Dimethylaminophenyl, 4-Acetylphenyl, Methoxyethylphenyl oder Ethoxymethylphenyl,
gegebenenfalls durch Aryl, Alkyl, Aryloxy, Alkyloxy, Heteroatome und/oder Heterocyclen substituiertes C₅ - C₁₂-Cycloalkyl beispielsweise Cyclopentyl, Cyclohexyl, Cyclooctyl, Cyclododecyl, Methylcyclopentyl, Dimethylcyclopentyl, Methylcyclohexyl, Dimethylcyclohexyl, Diethylcyclohexyl, Butylcyclohexyl, Methoxycyclohexyl, Dimethoxycyclohexyl, Diethoxycyclohexyl, Butylthiocyclohexyl, Chlorcyclohexyl, Dichlorcyclohexyl, Dichlorcyclopentyl sowie ein gesättigtes oder ungesättigtes bicyclisches System wie z.B. Norbornyl oder Norbornenyl,
ein fünf- bis sechsgliedriger, Sauerstoff-, Stickstoff- und/oder Schwefelatome aufweisender Heterocyclus beispielsweise Furyl, Thiophenyl, Pyrryl, Pyridyl, Indolyl, Benzoxazolyl, Dioxolyl, Dioxyl, Benzimidazolyl, Benzthiazolyl, Dimethylpyridyl, Methylchinolyl, Dimethylpyrryl, Methoxyfuryl, Dimethoxypyridyl, Difluorpyridyl, Methylthiophenyl, Isopropylthiophenyl oder tert.-Butylthiophenyl,
C₁ bis C₄-Alkyl beispielsweise Methyl, Ethyl, Propyl, Isopropyl, n-Butyl, sec-Butyl oder tert.-Butyl, sowie
gegebenenfalls durch Aryl, Alkyl, Aryloxy, Alkyloxy, Heteroatome und/oder Heterocyclen substituiertes C₆ - C₁₂-Aryl oder Arylsulfonyl beispielsweise Phenyl, 2,6-Dinitrophenyl, 2,4-Dinitrophenyl, 2-Nitrophenyl, 4-Nitrophenyl, Formyl, Acetyl, Propionyl, Carbamoyl, Phenylsulfonyl oder 4-Methylphenylsulfonyl.

Die Anzahl der Substituenten in den angegebenen Resten ist nicht beschränkt. In der Regel beträgt sie bei Resten mit ein bis drei Kohlenstoffatomen bis zu 3 Substituenten, bevorzugt bis zu 2 und besonders bevorzugt bis zu einem. Bei Resten mit vier bis sechs Kohlenstoffatomen beträgt sie in der Regel bis zu 4 Substituenten, bevorzugt bis zu 3 und besonders bevorzugt bis zu einem. Bei Resten mit mehr als sieben Kohlenstoffatomen beträgt sie in der Regel bis zu 6 Substituenten, bevorzugt bis zu 4 und besonders bevorzugt bis zu zwei.

R¹ ist bevorzugt Phenyl, Tolyl, α-Naphthyl, β-Naphthyl, 2,6- oder 2,4-Dichlorphenyl, 2,4,6-Trichlorphenyl, 2,6- oder 2,4-Dimethylphenyl, 2,4,6-Trimethylphenyl, 2,6- oder 2,4-Diethylphenyl, 2-iso-Propylphenyl, 2-tert.-Butylphenyl, 2,6- oder 2,4-Dimethoxyphenyl, 2,6- oder 2,4-Diethoxyphenyl, Methylnaphthyl, 2,6-Dimethylphenyl, 2,4,6-Trimethylphenyl, 2,6-Dimethoxyphenyl, 2,6-Dichlorphenyl, 2,6-Dinitrophenyl, 2,5-Dimethylcyclopentyl, 2,6-Dimethylcyclohexyl, 2,6-Diethylcyclohexyl, 2,6-Dimethoxycyclohexyl, 2,6-Diethoxycyclohexyl, 2,6-Dichlorcyclohexyl, 2,5-Dichlorcyclopentyl, 2-Methylphenyl, 2-Methoxyphenyl oder 2-Chlorphenyl.

R¹ ist ganz besonders bevorzugt Phenyl, α-Naphthyl, 2,6-Dichlorphenyl, 2,4,6-Trichlorphenyl, 2,6-Dimethylphenyl, 2,4,6-Trimethylphenyl, 2,6-Diethylphenyl, 2,6-Dimethoxyphenyl, 2,6-Diethoxyphenyl, 2,6-Dimethylphenyl, 2,4,6-Trimethylphenyl, 2,6-Dimethoxyphenyl, 2,6-Dichlorphenyl, 2,6-Dinitrophenyl, 2,6-Dimethylcyclohexyl, 2,6-Diethylcyclohexyl, 2,6-Dimethoxycyclohexyl, 2,6-Diethoxycyclohexyl oder 2,6-Dichlorcyclohexyl. R¹ ist insbesondere Phenyl, 2,6-Dichlorphenyl, 2,4,6-Trichlorphenyl, 2,6-Dimethylphenyl, 2,4,6-Trimethylphenyl oder 2,6-Dimethoxyphenyl.

R² ist bevorzugt 2,4,4-Trimethylpentyl, Benzyl, p-Chlorbenzyl, 2,4-Dichlorbenzyl, p-Methoxybenzyl, Methoxy, Ethoxy, n-Propyloxy, iso-Propyloxy, n-Butyloxy, iso-Butyloxy, sek.-Butyloxy, tert.-Butyloxy, 6-Hydroxy-1,4-dioxohexyl, 9-Hydroxy-1,4,7-trioxononyl, 12-Hydroxy-1,4,7,10-tetraoxododecyl, 6-Methoxy-1,4-dioxohexyl, 9-Methoxy-1,4,7-trioxononyl, 12-Methoxy-1,4,7,10-tetraoxododecyl, 6-Ethoxy-1,4-dioxohexyl, 9-Ethoxy-1,4,7-trioxononyl, 12-Ethoxy-1,4,7,10-tetraoxododecyl, 8-Hydroxy-1,5-dioxooctyl, 12-Hydroxy-1,5,9-trioxooctyl, 16-Hydroxy-1,5,9,13-tetraoxohexadecyl, 10-Hydroxy-1,6-dioxodecyl, 15-Hydroxy-1,6,11-trioxopentadecyl, Vinyl, 1-Propenyl, Allyl, Methallyl, 1,1-Dimethylallyl, 2-Butenyl, 2-Hexenyl, 2-Phenylvinyl, 2-Methoxyvinyl, 2-Ethoxyvinyl, 2-Chlorvinyl, Phenyl, Tolyl, Xylyl, α-Naphthyl, β-Naphthyl, 4-Diphenylyl, 2-, 3- oder 4-Chlorphenyl, 2,4- oder 2,6-Dichlorphenyl, 2,4,6-Trichlorphenyl, 2-, 3- oder 4-Methylphenyl, 2,4-oder 2,6-Dimethylphenyl, 2,4,6-Trimethylphenyl, 2-, 3- oder 4-Ethylphenyl, 2,4- oder 2,6-Diethylphenyl, 2-, 3- oder 4-iso-Propylphenyl, 2-, 3- oder 4-tert.-Butylphenyl, 2-, 3- oder 4-Methoxyphenyl, 2,4- oder 2,6-Dimethoxyphenyl, 2-, 3- oder 4-Ethoxyphenyl, Methylnaphthyl, Chlornaphthyl, Ethoxynaphthyl, 2,6-Dimethylphenyl, 2,4,6-Trimethylphenyl, 2,4- oder 2,6-Dimethoxyphenyl, 2,4- oder 2,6-Dichlorphenyl, 2- oder 4-Nitrophenyl, 2,4- oder 2,6-Dinitrophenyl, 4-Dimethylaminophenyl, 4-Acetylphenyl oder R¹-(C=Y)-.

R² ist besonders bevorzugt Benzyl, p-Chlorbenzyl, 2,4-Dichlorbenzyl, p-Methoxybenzyl, Methoxy, Ethoxy, n-Propyloxy, iso-Propyloxy, n-Butyloxy, iso-Butyloxy, sek.-Butyloxy, tert.-Butyloxy, 6-Hydroxy-1,4-dioxohexyl, 9-Hydroxy-1,4,7-trioxononyl, 12-Hydroxy-1,4,7,10-tetraoxododecyl, 6-Methoxy-1,4-dioxohexyl, 9-Methoxy-1,4,7-trioxononyl, 12-Methoxy-1,4,7,10-tetraoxododecyl, 6-Ethoxy-1,4-dioxohexyl, 9-Ethoxy-1,4,7-trioxononyl, 12-Ethoxy-1,4,7,10-tetraoxododecyl, 8-Hydroxy-1,5-dioxooctyl, 12-Hydroxy-1,5,9-trioxooctyl, 16-Hydroxy-1,5,9,13-tetraoxohexadecyl, 10-Hydroxy-1,6-dioxodecyl, 15-Hydroxy-1,6,11-trioxopentadecyl, Vinyl, 2-Butenyl, 2-Phenylvinyl, Phenyl, Tolyl, Xylyl, α-Naphthyl, β-Naphthyl, 4-Diphenylyl, 2-, 3- oder 4-Chlorphenyl, 2,4- oder 2,6-Dichlorphenyl, 2,4,6-Trichlorphenyl, 2-, 3- oder 4-Methylphenyl, 2,4- oder 2,6-Dimethylphenyl, 2,4,6-Trimethylphenyl, 2-, 3- oder 4-Ethylphenyl, 2-, 3- oder 4-iso-Propylphenyl, 2-, 3- oder 4-tert.-Butylphenyl, 2-, 3- oder 4-Methoxyphenyl, 2,4- oder 2,6-Dimethoxyphenyl, 2-, 3- oder 4-Ethoxyphenyl, Methylnaphthyl, Chlornaphthyl, Ethoxynaphthyl, 2- oder 4-Nitrophenyl, 2,4- oder 2,6-Dinitrophenyl, 4-Dimethylaminophenyl, 4-Acetylphenyl oder R¹-(C=Y)-.

R² ist ganz besonders bevorzugt Methoxy, Ethoxy, Methoxy, n-Propoxy, iso-Propoxy, n-Butoxy, *sek*-Butoxy, *iso*-Butoxy oder *tert*-Butoxy, 6-Hydroxy-1,4-dioxohexyl, 9-Hydroxy-1,4,7-trioxononyl, 12-Hydroxy-1,4,7,10-tetraoxododecyl, 8-Hydroxy-1,5-dioxooctyl, 12-Hydroxy-1,5,9-trioxooctyl, 16-Hydroxy-1,5,9,13-tetraoxohexadecyl, 10-Hydroxy-1,6-dioxodecyl, 15-Hydroxy-1,6,11-trioxopentadecyl, Phenyl, Xylyl, α-Naphthyl, β-Naphthyl, 4-Diphenylyl, 2-, 3- oder 4-Chlorphenyl, 2,4-Dichlorphenyl, 2-, 3- oder 4-Methylphenyl, 2,4-Dimethylphenyl, 2-, 3- oder 4-Ethylphenyl, 2-, 3- oder 4-Methoxyphenyl, 2,4-Dimethoxyphenyl, 2-, 3- oder 4-Ethoxyphenyl, Methylnaphthyl, Chlornaphthyl, Ethoxynaphthyl, 2- oder 4-Nitrophenyl oder R'-(C=Y)-.

R³ ist insbesondere Methoxy, Ethoxy, Methoxy, n-Propoxy, iso-Propoxy, n-Butoxy, *sek*-Butoxy, *iso*-Butoxy oder *tert*-Butoxy, Phenyl, 4-Diphenylyl, 2-, 3- oder 4-Chlorphenyl, 2-, 3- oder 4-Methylphenyl, 2-, 3- oder 4-Methoxyphenyl oder 2-, 3- oder 4-Ethoxyphenyl. R² ist speziell Phenyl, Methoxy oder Ethoxy.

Y ist bevorzugt O, S oder NR³.

Y ist besonders bevorzugt O oder S und ganz besonders bevorzugt O.

Z ist bevorzugt O, S, NR³ oder ein freies Elektronenpaar, besonders bevorzugt O, S oder ein freies Elektronenpaar, ganz besonders bevorzugt O oder S und insbesondere O.

R³ ist bevorzugt Wasserstoff, Methyl, *tert*.-Butyl, Phenyl oder SO₃H, besonders bevorzugt Wasserstoff, *tert*. -Butyl, Phenyl oder SO₃H und ganz besonders bevorzugt Wasserstoff, *tert*.-Butyl oder Phenyl.

R⁴ ist bevorzugt Wasserstoff, Methyl, Phenyl, 2,4-Dinitrophenyl, Carbamoyl, Phenylsulfonyl oder 4-Methylphenylsulfonyl, besonders bevorzugt Wasserstoff, Phenyl, 2,4-Dinitrophenyl oder Phenylsulfonyl, ganz besonders bevorzugt Wasserstoff, 2,4-Dinitrophenyl oder Phenylsulfonyl und insbesondere Wasserstoff oder 2,4-Dinitrophenyl.

FG ist bevorzugt -Cl, -CN, -OCN, -SCN, -N⁺R⁶R⁷R⁸, -O(CO)R⁵, -O(CO)OR⁵ oder -(SO₂)R⁵.

FG ist ganz besonders bevorzugt -Cl, -O(CO)R⁵, -O(CO)OR⁵ oder -(SO₂)R⁵ und insbesondere -Cl oder -(SO₂)R⁵.

R⁵ ist bevorzugt Methoxy, Ethoxy, n-Propyloxy, n-Butyloxy, Methyl, Ethyl, n-Propyl, n-Butyl, *tert*.-Butyl, Phenyl, 4-Methylphenyl, Trifluormethyl oder 4-Bromphenyl.

R⁵ ist besonders bevorzugt Methoxy, Ethoxy, n-Butyloxy, Methyl, Ethyl, n-Butyl, Phenyl, 4-Methylphenyl, Trifluormethyl oder 4-Bromphenyl.

R⁵ ist ganz besonders bevorzugt n-Butyloxy, Methyl, Ethyl, n-Butyl, Phenyl oder 4-Methylphenyl und insbesondere Methyl oder 4-Methylphenyl.

R⁶, R⁷ und R⁸ sind unabhängig voneinander bevorzugt Methyl, Ethyl, n-Propyl, n-Butyl, Benzyl, 2-Hydroxyethyl, 2-Hydroxypropyl, 2-Cyanethyl, 2-Methoxycarbonylethyl, 2-Ethoxycarbonylethyl oder 2-Butoxycarbonylethyl.

R⁶, R⁷ und R⁸ sind unabhängig voneinander besonders bevorzugt Methyl, Benzyl, 2-Hydroxyethyl, 2-Cyanethyl, 2-Methoxycarbonylethyl, 2-Ethoxycarbonylethyl oder 2-Butoxycarbonylethyl.

R⁶, R⁷ und R⁸ sind unabhängig voneinander ganz besonders bevorzugt Methyl, Benzyl, 2-Hydroxyethyl oder 2-Butoxycarbonylethyl und insbesondere Methyl, 2-Hydroxyethyl oder 2-Butoxycarbonylethyl.

Insbesondere sind von den Verbindungen, die durch die Formel (I) beschrieben sind, die folgenden Individuen I-1 bis I-372 bevorzugt, in denen die Reste in Formel (I) die folgenden Bedeutungen haben:

| I- | R¹ | R² | Y | Z | FG |
|---|---|---|---|---|---|
| 1 | TMP | Ph | O | O | Cl |
| 2 | TMP | Ph | O | O | I |
| 3 | TMP | Ph | O | O | OCN |
| 4 | TMP | Ph | O | O | SCN |
| 5 | TMP | Ph | O | O | CN |
| 6 | TMP | Ph | O | O | Acetyloxy (-O(CO)CH₃) |
| 7 | TMP | Ph | O | O | Benzoyloxy (-O(CO)Ph) |
| 8 | TMP | Ph | O | O | Formyloxy (-O(CO)H) |
| 9 | TMP | Ph | O | O | Methoxycarbonyloxy (-O(CO)OCH₃) |
| 10 | TMP | Ph | O | O | Ethoxycarbonyloxy (-O(CO)OCH₂CH₃) |
| 11 | TMP | Ph | O | O | n-Butoxycarbonyloxy (-O(CO)OCH₂CH₂CH₂CH₃) |
| 12 | TMP | Ph | O | O | Chlorcarbonyloxy (-O(CO)Cl) |
| 13 | TMP | Ph | O | O | Chlorsulfinyloxy (-O(SO)Cl) |
| 14 | TMP | Ph | O | O | Methoxysulfinyloxy (-O(SO)OCH₃) |
| 15 | TMP | Ph | O | O | Ethoxysulfinyloxy (-O(SO)OCH₂CH₃) |
| 16 | TMP | Ph | O | O | n-Butoxysulfinyloxy (-O(SO)OCH₂CH₂CH₂CH₃) |
| 17 | TMP | Ph | O | O | Chlorsulfuryloxy (-O(SO₂)Cl) |
| 18 | TMP | Ph | O | O | Methoxysulfuryloxy (-O(S0₂)OCH₃) |
| 19 | TMP | Ph | O | O | Ethoxysulfuryloxy (-O(SO₂)OCH₂CH₃) |
| 20 | TMP | Ph | O | O | Methylsulfonyloxy (-O(SO₂)CH₃) |
| 21 | TMP | Ph | O | O | Trifluormethylsulfonyloxy (-O(SO₂)CF₃) |
| 22 | TMP | Ph | O | O | Benzolsulfonyloxy (-O(SO₂)Ph) |
| 23 | TMP | Ph | O | O | p-Toluolsulfonyloxy (-O(SO₂)Ph-4-CH₃) |
| 24 | TMP | Ph | O | O | Dodecylbenzolsulfonyloxy |
| 25 | TMP | Ph | O | O | p-Brombenzolsulfonyloxy (-O(SO₂)Ph-4-Br) |
| 26 | TMP | Ph | O | O | Diethyl-(2-hydroxyethyl)ammonium |
| 27 | TMP | Ph | O | O | Benzyl-diethyl-ammonium |
| 28 | TMP | Ph | O | O | Tris-(2-hydroxyethyl)ammonium |
| 29 | TMP | Ph | O | O | Dimethyl-(2-hydroxyethyl)ammonium |
| 30 | TMP | Ph | O | O | Benzyl-dimethyl-ammonium |
| 31 | TMP | Ph | O | O | Trimethylammonium |
| 32 | TMP | OEt | O | O | Cl |
| 33 | TMP | OEt | O | O | I |
| 34 | TMP | OEt | O | O | OCN |
| 35 | TMP | OEt | O | O | SCN |
| 36 | TMP | OEt | O | O | CN |
| 37 | TMP | OEt | O | O | Acetyloxy (-O(CO)CH₃) |
| 38 | TMP | OEt | O | O | Benzoyloxy (-O(CO)Ph) |
| 39 | TMP | OEt | O | O | Formyloxy (-O(CO)H) |
| 40 | TMP | OEt | O | O | Methoxycarbonyloxy (-O(CO)OCH₃) |
| 41 | TMP | OEt | O | O | Ethoxycarbonyloxy (-O(CO)OCH₂CH₃) |
| 42 | TMP | OEt | O | O | n-Butoxycarbonyloxy (-O(CO)OCH₂CH₂CH₂CH₃) |
| 43 | TMP | OEt | O | O | Chlorcarbonyloxy (-O(CO)Cl) |
| 44 | TMP | OEt | O | O | Chlorsulfinyloxy (-O(SO)Cl) |
| 45 | TMP | OEt | O | O | Methoxysulfinyloxy (-O(SO)OCH₃) |
| 46 | TMP | OEt | O | O | Ethoxysulfinyloxy (-O(SO)OCH₂CH₃) |
| 47 | TMP | OEt | O | O | n-Butoxysulfinyloxy (-O(SO)OCH₂CH₂CH₂CH₃) |
| 48 | TMP | OEt | O | O | Chlorsulfuryloxy (-O(SO₂)Cl) |
| 49 | TMP | OEt | O | O | Methoxysulfuryloxy (-O(S0₂)OCH₃) |
| 50 | TMP | OEt | O | O | Ethoxysulfuryloxy (-O(SO₂)OCH₂CH₃) |
| 51 | TMP | OEt | O | O | Methylsulfonyloxy (-O(SO₂)CH₃) |
| 52 | TMP | OEt | O | O | Trifluormethylsulfonyloxy (-O(SO₂)CF₃) |
| 53 | TMP | OEt | O | O | Benzolsulfonyloxy (-O(SO₂)Ph) |
| 54 | TMP | OEt | O | O | p-Toluolsulfonyloxy (-O(SO₂)Ph-4-CH₃) |
| 55 | TMP | OEt | O | O | Dodecylbenzolsulfonyloxy |
| 56 | TMP | OEt | O | O | p-Brombenzolsulfonyloxy (-O(SO₂)Ph-4-Br) |
| 57 | TMP | OEt | O | O | Diethyl-(2-hydroxyethyl)ammonium |
| 58 | TMP | OEt | O | O | Benzyl-diethyl-ammonium |
| 59 | TMP | OEt | O | O | Tris-(2-hydroxyethyl)ammonium |
| 60 | TMP | OEt | O | O | Dimethyl-(2-hydroxyethyl)ammonium |
| 61 | TMP | OEt | O | O | Benzyl-dimethyl-ammonium |
| 62 | TMP | OEt | O | O | Trimethylammonium |
| 63 | TMP | TMB | O | O | Cl |
| 64 | TMP | TMB | O | O | I |
| 65 | TMP | TMB | O | O | OCN |
| 66 | TMP | TMB | O | O | SCN |
| 67 | TMP | TMB | O | O | CN |
| 68 | TMP | TMB | O | O | Acetyloxy (-O(CO)CH₃) |
| 69 | TMP | TMB | O | O | Benzoyloxy (-O(CO)Ph) |
| 70 | TMP | TMB | O | O | Formyloxy (-O(CO)H) |
| 71 | TMP | TMB | O | O | Methoxycarbonyloxy (-O(CO)OCH₃) |
| 72 | TMP | TMB | O | O | Ethoxycarbonyloxy (-O(CO)OCH₂CH₃) |
| 73 | TMP | TMB | O | O | n-Butoxycarbonyloxy (-O(CO)OCH₂CH₂CH₂CH₃) |
| 74 | TMP | TMB | O | O | Chlorcarbonyloxy (-O(CO)Cl) |
| 75 | TMP | TMB | O | O | Chlorsulfinyloxy (-O(SO)Cl) |
| 76 | TMP | TMB | O | O | Methoxysulfinyloxy (-O(SO)OCH₃) |
| 77 | TMP | TMB | O | O | Ethoxysulfinyloxy (-O(SO)OCH₂CH₃) |
| 78 | TMP | TMB | O | O | n-Butoxysulfinyloxy (-O(SO)OCH₂CH₂CH₂CH₃) |
| 79 | TMP | TMB | O | O | Chlorsulfuryloxy (-O(SO₂)Cl) |
| 80 | TMP | TMB | O | O | Methoxysulfuryloxy (-O(SO₂)OCH₃) |
| 81 | TMP | TMB | O | O | Ethoxysulfuryloxy (-O(SO₂)OCH₂CH₃) |
| 82 | TMP | TMB | O | O | Methylsulfonyloxy (-O(SO₂)CH₃) |
| 83 | TMP | TMB | O | O | Trifluormethylsulfonyloxy (-O(SO₂)CF₃) |
| 84 | TMP | TMB | O | O | Benzolsulfonyloxy (-O(SO₂)Ph) |
| 85 | TMP | TMB | O | O | p-Toluolsulfonyloxy (-O(SO₂)Ph-4-CH₃) |
| 86 | TMP | TMB | O | O | Dodecylbenzolsulfonyloxy |
| 87 | TMP | TMB | O | O | p-Brombenzolsulfonyloxy (-O(SO₂)Ph-4-Br) |
| 88 | TMP | TMB | O | O | Diethyl-(2-hydroxyethyl)ammonium |
| 89 | TMP | TMB | O | O | Benzyl-diethyl-ammonium |
| 90 | TMP | TMB | O | O | Tris-(2-hydroxyethyl)ammonium |
| 91 | TMP | TMB | O | O | Dimethyl-(2-hydroxyethyl)ammonium |
| 92 | TMP | TMB | O | O | Benzyl-dimethyl-ammonium |
| 93 | TMP | TMB | O | O | Trimethylammonium |
| 94 | DMP | Ph | O | O | Cl |
| 95 | DMP | Ph | O | O | I |
| 96 | DMP | Ph | O | O | OCN |
| 97 | DMP | Ph | O | O | SCN |
| 98 | DMP | Ph | O | O | CN |
| 99 | DMP | Ph | O | O | Acetyloxy (-O(CO)CH₃) |
| 100 | DMP | Ph | O | O | Benzoyloxy (-O(CO)Ph) |
| 101 | DMP | Ph | O | O | Formyloxy (-O(CO)H) |
| 102 | DMP | Ph | O | O | Methoxycarbonyloxy (-O(CO)OCH₃) |
| 103 | DMP | Ph | O | O | Ethoxycarbonyloxy (-O(CO)OCH₂CH₃) |
| 104 | DMP | Ph | O | O | n-Butoxycarbonyloxy (-O(CO)OCH₂CH₂CH₂CH₃) |
| 105 | DMP | Ph | O | O | Chlorcarbonyloxy (-O(CO)Cl) |
| 106 | DMP | Ph | O | O | Chlorsulfinyloxy (-O(SO)Cl) |
| 107 | DMP | Ph | O | O | Methoxysulfinyloxy (-O(SO)OCH₃) |
| 108 | DMP | Ph | O | O | Ethoxysulfinyloxy (-O(SO)OCH₂CH₃) |
| 109 | DMP | Ph | O | O | n-Butoxysulfinyloxy (-O(SO)OCH₂CH₂CH₂CH₃) |
| 110 | DMP | Ph | O | O | Chlorsulfuryloxy (-O(SO₂)Cl) |
| 111 | DMP | Ph | O | O | Methoxysulfuryloxy (-O(SO₂)OCH₃) |
| 112 | DMP | Ph | O | O | Ethoxysulfuryloxy (-O(SO₂)OCH₂CH₃) |
| 113 | DMP | Ph | O | O | Methylsulfonyloxy (-O(SO₂)CH₃) |
| 114 | DMP | Ph | O | O | Trifluormethylsulfonyloxy (-O(SO₂)CF₃) |
| 115 | DMP | Ph | O | O | Benzolsulfonyloxy (-O(SO₂)Ph) |
| 116 | DMP | Ph | O | O | p-Toluolsulfonyloxy (-O(SO₂)Ph-4-CH₃) |
| 117 | DMP | Ph | O | O | Dodecylbenzolsulfonyloxy |
| 118 | DMP | Ph | O | O | p-Brombenzolsulfonyloxy (-O(SO₂)Ph-4-Br) |
| 119 | DMP | Ph | O | O | Diethyl-(2-hydroxyethyl)ammonium |
| 120 | DMP | Ph | O | O | Benzyl-diethyl-ammonium |
| 121 | DMP | Ph | O | O | Tris-(2-hydroxyethyl)ammonium |
| 122 | DMP | Ph | O | O | Dimethyl-(2-hydroxyethyl)ammonium |
| 123 | DMP | Ph | O | O | Benzyl-dimethyl-ammonium |
| 124 | DMP | Ph | O | O | Trimethylammonium |
| 125 | DMP | OEt | O | O | Cl |
| 126 | DMP | OEt | O | O | I |
| 127 | DMP | OEt | O | O | OCN |
| 128 | DMP | OEt | O | O | SCN |
| 129 | DMP | OEt | O | O | CN |
| 130 | DMP | OEt | O | O | Acetyloxy (-O(CO)CH₃) |
| 131 | DMP | OEt | O | O | Benzoyloxy (-O(CO)Ph) |
| 132 | DMP | OEt | O | O | Formyloxy (-O(CO)H) |
| 133 | DMP | OEt | O | O | Methoxycarbonyloxy (-O(CO)OCH₃) |
| 134 | DMP | OE t | O | O | Ethoxycarbonyloxy (-O(CO)OCH₂CH₃) |
| 135 | DMP | OEt | 0 | 0 | n-Butoxycarbonyloxy (-O(CO)OCH₂CH₂CH₂CH₃) |
| 136 | DMP | OEt | O | O | Chlorcarbonyloxy (-O(CO)Cl) |
| 137 | DMP | OEt | O | 0 | Chlorsulfinyloxy (-O(SO)Cl) |
| 138 | DMP | OEt | O | O | Methoxysulfinyloxy (-O(SO)OCH₃) |
| 139 | DMP | OEt | O | O | Ethoxysulfinyloxy (-O(SO)OCH₂CH₃) |
| 140 | DMP | OEt | O | O | n-Butoxysulfinyloxy (-O(SO)OCH₂CH₂CH₂CH₃) |
| 141 | DMP | OEt | O | O | Chlorsulfuryloxy (-O(SO₂)Cl) |
| 142 | DMP | OEt | O | O | Methoxysulfuryloxy (-O(S0₂)OCH₃) |
| 143 | DMP | OEt | O | O | Ethoxysulfuryloxy (-O(SO₂)OCH₂CH₃) |
| 144 | DMP | OEt | O | O | Methylsulfonyloxy (-O(SO₂)CH₃) |
| 145 | DMP | OEt | O | O | Trifluormethylsulfonyloxy (-O(S0₂)CF₃) |
| 146 | DMP | OEt | O | O | Benzolsulfonyloxy (-O(SO₂)Ph) |
| 147 | DMP | OEt | O | O | p-Toluolsulfonyloxy (-O(SO₂)Ph-4-CH₃) |
| 148 | DMP | OEt | O | O | Dodecylbenzolsulfonyloxy |
| 149 | DMP | OEt | O | O | p-Brombenzolsulfonyloxy (-O(SO₂)Ph-4-Br) |
| 150 | DMP | OEt | O | O | Diethyl-(2-hydroxyethyl)ammonium |
| 151 | DMP | OEt | O | O | Benzyl-diethyl-ammonium |
| 152 | DMP | OEt | O | O | Tris-(2-hydroxyethyl)ammonium |
| 153 | DMP | OEt | O | O | Dimethyl-(2-hydroxyethyl)ammonium |
| 154 | DMP | OEt | O | O | Benzyl-dimethyl-ammonium |
| 155 | DMP | OEt | O | O | Trimethylammonium |
| 156 | DMP | TMB | O | O | Cl |
| 157 | DMP | TMB | O | O | I |
| 158 | DMP | TMB | O | O | OCN |
| 159 | DMP | TMB | O | O | SCN |
| 160 | DMP | TMB | O | O | CN |
| 161 | DMP | TMB | O | O | Acetyloxy (-O(CO)CH₃) |
| 162 | DMP | TMB | O | O | Benzoyloxy (-O(CO)Ph) |
| 163 | DMP | TMB | O | O | Formyloxy (-O(CO)H) |
| 164 | DMP | TMB | O | O | Methoxycarbonyloxy (-O(CO)OCH₃) |
| 165 | DMP | TMB | O | O | Ethoxycarbonyloxy (-O(CO)OCH₂CH₃) |
| 166 | DMP | TMB | O | O | n-Butoxycarbonyloxy (-O(CO)OCH₂CH₂CH₂CH₃) |
| 167 | DMP | TMB | O | O | Chlorcarbonyloxy (-O(CO)Cl) |
| 168 | DMP | TMB | O | O | Chlorsulfinyloxy (-O(SO)Cl) |
| 169 | DMP | TMB | O | O | Methoxysulfinyloxy (-O(SO)OCH₃) |
| 170 | DMP | TMB | O | O | Ethoxysulfinyloxy (-O(SO)OCH₂CH₃) |
| 171 | DMP | TMB | O | O | n-Butoxysulfinyloxy (-O(SO)OCH₂CH₂CH₂CH₃) |
| 172 | DMP | TMB | O | O | Chlorsulfuryloxy (-O(S0₂)Cl) |
| 173 | DMP | TMB | O | O | Methoxysulfuryloxy (-O(S0₂)OCH₃) |
| 174 | DMP | TMB | O | O | Ethoxysulfuryloxy (-O(SO₂)OCH₂CH₃) |
| 175 | DMP | TMB | O | O | Methylsulfonyloxy (-O(SO₂)CH₃) |
| 176 | DMP | TMB | O | O | Trifluormethylsulfonyloxy (-O(SO₂)CF₃) |
| 177 | DMP | TMB | O | O | Benzolsulfonyloxy (-O(SO₂)Ph) |
| 178 | DMP | TMB | O | O | p-Toluolsulfonyloxy (-O(SO₂)Ph-4-CH₃) |
| 179 | DMP | TMB | O | O | Dodecylbenzolsulfonyloxy |
| 180 | DMP | TMB | O | O | p-Brombenzolsulfonyloxy (-O(SO₂)Ph-4-Br) |
| 181 | DMP | TMB | O | O | Diethyl-(2-hydroxyethyl)ammonium |
| 182 | DMP | TMB | O | O | Benzyl-diethyl-ammonium |
| 183 | DMP | TMB | O | O | Tris-(2-hydroxyethyl)ammonium |
| 184 | DMP | TMB | O | O | Dimethyl-(2-hydroxyethyl)ammonium |
| 185 | DMP | TMB | O | O | Benzyl-dimethyl-ammonium |
| 186 | DMP | TMB | O | O | Trimethylammonium |
| 187 | DMOP | Ph | O | O | Cl |
| 188 | DMOP | Ph | O | O | I |
| 189 | DMOP | Ph | O | O | OCN |
| 190 | DMOP | Ph | O | O | SCN |
| 191 | DMOP | Ph | O | O | CN |
| 192 | DMOP | Ph | O | O | Acetyloxy (-O(CO)CH₃) |
| 193 | DMOP | Ph | O | O | Benzoyloxy (-O(CO)Ph) |
| 194 | DMOP | Ph | O | O | Formyloxy (-O(CO)H) |
| 195 | DMOP | Ph | O | O | Methoxycarbonyloxy (-O(CO)OCH₃) |
| 196 | DMOP | Ph | O | O | Ethoxycarbonyloxy (-O(CO)OCH₂CH₃) |
| 197 | DMOP | Ph | O | O | n-Butoxycarbonyloxy (-O(CO)OCH₂CH₂CH₂CH₃) |
| 198 | DMOP | Ph | O | O | Chlorcarbonyloxy (-O(CO)Cl) |
| 199 | DMOP | Ph | O | O | Chlorsulfinyloxy (-O(SO)Cl) |
| 200 | DMOP | Ph | O | O | Methoxysulfinyloxy (-O(SO)OCH₃) |
| 201 | DMOP | Ph | O | O | Ethoxysulfinyloxy (-O(SO)OCH₂CH₃) |
| 202 | DMOP | Ph | O | O | n-Butoxysulfinyloxy (-O(SO)OCH₂CH₂CH₂CH₃) |
| 203 | DMOP | Ph | O | O | Chlorsulfuryloxy (-O(SO₂)Cl) |
| 204 | DMOP | Ph | O | O | Methoxysulfuryloxy (-O(SO₂)OCH₃) |
| 205 | DMOP | Ph | O | O | Ethoxysulfuryloxy (-O(SO₂)OCH₂CH₃) |
| 206 | DMOP | Ph | O | O | Methylsulfonyloxy (-O(SO₂)CH₃) |
| 207 | DMOP | Ph | O | O | Trifluormethylsulfonyloxy (-O(SO₂)CF₃) |
| 208 | DMOP | Ph | O | O | Benzolsulfonyloxy (-O(SO₂)Ph) |
| 209 | DMOP | Ph | O | O | p-Toluolsulfonyloxy (-O(SO₂)Ph-4-CH₃) |
| 210 | DMOP | Ph | O | O | Dodecylbenzolsulfonyloxy |
| 211 | DMOP | Ph | O | O | p-Brombenzolsulfonyloxy (-O(SO₂)Ph-4-Br) |
| 212 | DMOP | Ph | O | O | Diethyl-(2-hydroxyethyl)ammonium |
| 213 | DMOP | Ph | O | O | Benzyl-diethyl-ammonium |
| 214 | DMOP | Ph | O | O | Tris-(2-hydroxyethyl)ammonium |
| 215 | DMOP | Ph | O | O | Dimethyl-(2-hydroxyethyl)ammonium |
| 216 | DMOP | Ph | O | O | Benzyl-dimethyl-ammonium |
| 217 | DMOP | Ph | O | O | Trimethylammonium |
| 218 | DMOP | OEt | O | O | Cl |
| 219 | DMOP | OEt | O | O | I |
| 220 | DMOP | OEt | O | O | OCN |
| 221 | DMOP | OEt | O | O | SCN |
| 222 | DMOP | OEt | 0 | 0 | CN |
| 223 | DMOP | OEt | O | O | Acetyloxy (-O(CO)CH₃) |
| 224 | DMOP | OEt | O | O | Benzoyloxy (-O(CO)Ph) |
| 225 | DMOP | OEt | O | O | Formyloxy (-O(CO)H) |
| 226 | DMOP | OEt | O | O | Methoxycarbonyloxy (-O(CO)OCH₃) |
| 227 | DMOP | OEt | O | O | Ethoxycarbonyloxy (-O(CO)OCH₂CH₃) |
| 228 | DMOP | OEt | O | O | n-Butoxycarbonyloxy (-O(CO)OCH₂CH₂CH₂CH₃) |
| 229 | DMOP | OEt | O | O | Chlorcarbonyloxy (-O(CO)Cl) |
| 230 | DMOP | OEt | O | O | Chlorsulfinyloxy (-O(SO)Cl) |
| 231 | DMOP | OEt | O | O | Methoxysulfinyloxy (-O(SO)OCH₃) |
| 232 | DMOP | OEt | O | O | Ethoxysulfinyloxy (-O(SO)OCH₂CH₃) |
| 233 | DMOP | OEt | O | O | n-Butoxysulfinyloxy (-O(SO)OCH₂CH₂CH₂CH₃) |
| 234 | DMOP | OEt | O | O | Chlorsulfuryloxy (-O(SO₂)Cl) |
| 235 | DMOP | OEt | O | O | Methoxysulfuryloxy (-O(SO₂)OCH₃) |
| 236 | DMOP | OEt | O | O | Ethoxysulfuryloxy (-O(SO₂)OCH₂CH₃) |
| 237 | DMOP | OEt | O | O | Methylsulfonyloxy (-O(SO₂)CH₃) |
| 238 | DMOP | OEt | O | O | Trifluormethylsulfonyloxy (-O(SO₂)CF₃) |
| 239 | DMOP | OEt | O | O | Benzolsulfonyloxy (-O(SO₂)Ph) |
| 240 | DMOP | OEt | O | O | p-Toluolsulfonyloxy (-O(SO₂)Ph-4-CH₃) |
| 241 | DMOP | OEt | O | O | Dodecylbenzolsulfonyloxy |
| 242 | DMOP | OEt | O | O | p-Brombenzolsulfonyloxy (-O(SO₂)Ph-4-Br) |
| 243 | DMOP | OEt | O | O | Diethyl-(2-hydroxyethyl)ammonium |
| 244 | DMOP | OEt | O | O | Benzyl-diethyl-ammonium |
| 245 | DMOP | OEt | O | O | Tris-(2-hydroxyethyl)ammonium |
| 246 | DMOP | OEt | O | O | Dimethyl-(2-hydroxyethyl)ammonium |
| 247 | DMOP | OEt | O | O | Benzyl-dimethyl-ammonium |
| 248 | DMOP | OEt | O | O | Trimethylammonium |
| 249 | DMOP | TMB | O | O | Cl |
| 250 | DMOP | TMB | O | O | I |
| 251 | DMOP | TMB | O | O | OCN |
| 252 | DMOP | TMB | O | O | SCN |
| 253 | DMOP | TMB | O | O | CN |
| 254 | DMOP | TMB | O | O | Acetyloxy (-O(CO)CH₃) |
| 255 | DMOP | TMB | O | O | Benzoyloxy (-O(CO)Ph) |
| 256 | DMOP | TMB | O | O | Formyloxy (-O(CO)H) |
| 257 | DMOP | TMB | O | O | Methoxycarbonyloxy (-O(CO)OCH₃) |
| 258 | DMOP | TMB | O | O | Ethoxycarbonyloxy (-O(CO)OCH₂CH₃) |
| 259 | DMOP | TMB | O | O | n-Butoxycarbonyloxy (-O(CO)OCH₂CH₂CH₂CH₃) |
| 260 | DMOP | TMB | O | O | Chlorcarbonyloxy (-O(CO)Cl) |
| 261 | DMOP | TMB | O | O | Chlorsulfinyloxy (-O(SO)Cl) |
| 262 | DMOP | TMB | O | O | Methoxysulfinyloxy (-O(SO)OCH₃) |
| 263 | DMOP | TMB | O | O | Ethoxysulfinyloxy (-O(SO)OCH₂CH₃) |
| 264 | DMOP | TMB | O | O | n-Butoxysulfinyloxy (-O(SO)OCH₂CH₂CH₂CH₃) |
| 265 | DMOP | TMB | O | O | Chlorsulfuryloxy (-O(SO₂)Cl) |
| 266 | DMOP | TMB | O | O | Methoxysulfuryloxy (-O(SO₂)OCH₃) |
| 267 | DMOP | TMB | O | O | Ethoxysulfuryloxy (-O(SO₂)OCH₂CH₃) |
| 268 | DMOP | TMB | O | O | Methylsulfonyloxy (-O(SO₂)CH₃) |
| 269 | DMOP | TMB | O | O | Trifluormethylsulfonyloxy (-O(SO₂)CF₃) |
| 270 | DMOP | TMB | O | O | Benzolsulfonyloxy (-O(SO₂)Ph) |
| 271 | DMOP | TMB | O | O | p-Toluolsulfonyloxy (-O(SO₂)Ph-4-CH₃) |
| 272 | DMOP | TMB | O | O | Dodecylbenzolsulfonyloxy |
| 273 | DMOP | TMB | O | O | p-Brombenzolsulfonyloxy (-O(SO₂)Ph-4-Br) |
| 274 | DMOP | TMB | O | O | Diethyl-(2-hydroxyethyl)ammonium |
| 275 | DMOP | TMB | O | O | Benzyl-diethyl-ammonium |
| 276 | DMOP | TMB | O | O | Tris-(2-hydroxyethyl)ammonium |
| 277 | DMOP | TMB | O | O | Dimethyl-(2-hydroxyethyl)ammonium |
| 278 | DMOP | TMB | O | O | Benzyl-dimethyl-ammonium |
| 279 | DMOP | TMB | O | O | Trimethylammonium |
| 280 | DCP | Ph | O | O | Cl |
| 281 | DCP | Ph | O | O | I |
| 282 | DCP | Ph | O | O | OCN |
| 283 | DCP | Ph | O | O | SCN |
| 284 | DCP | Ph | O | O | CN |
| 285 | DCP | Ph | O | O | Acetyloxy (-O(CO)CH₃) |
| 286 | DCP | Ph | O | O | Benzoyloxy (-O(CO)Ph) |
| 287 | DCP | Ph | O | O | Formyloxy (-O(CO)H) |
| 288 | DCP | Ph | O | O | Methoxycarbonyloxy (-O(CO)OCH₃) |
| 289 | DCP | Ph | O | O | Ethoxycarbonyloxy (-O(CO)OCH₂CH₃) |
| 290 | DCP | Ph | O | O | n-Butoxycarbonyloxy (-O(CO)OCH₂CH₂CH₂CH₃) |
| 291 | DCP | Ph | O | O | Chlorcarbonyloxy (-O(CO)Cl) |
| 292 | DCP | Ph | O | O | Chlorsulfinyloxy (-O(SO)Cl) |
| 293 | DCP | Ph | O | O | Methoxysulfinyloxy (-O(SO)OCH₃) |
| 294 | DCP | Ph | O | O | Ethoxysulfinyloxy (-O(SO)OCH₂CH₃) |
| 295 | DCP | Ph | O | O | n-Butoxysulfinyloxy (-O(SO)OCH₂CH₂CH₂CH₃) |
| 296 | DCP | Ph | O | O | Chlorsulfuryloxy (-O(SO₂)Cl) |
| 297 | DCP | Ph | O | O | Methoxysulfuryloxy (-O(SO₂)OCH₃) |
| 298 | DCP | Ph | O | O | Ethoxysulfuryloxy (-O(SO₂)OCH₂CH₃) |
| 299 | DCP | Ph | O | O | Methylsulfonyloxy (-O(SO₂)CH₃) |
| 300 | DCP | Ph | O | O | Trifluormethylsulfonyloxy (-O(SO₂)CF₃) |
| 301 | DCP | Ph | O | O | Benzolsulfonyloxy (-O(SO₂)Ph) |
| 302 | DCP | Ph | O | O | p-Toluolsulfonyloxy (-O(SO₂)Ph-4-CH₃) |
| 303 | DCP | Ph | O | O | Dodecylbenzolsulfonyloxy |
| 304 | DCP | Ph | O | O | p-Brombenzolsulfonyloxy (-O(SO₂)Ph-4-Br) |
| 305 | DCP | Ph | O | O | Diethyl-(2-hydroxyethyl)ammonium |
| 306 | DCP | Ph | O | O | Benzyl-diethyl-ammonium |
| 307 | DCP | Ph | O | O | Tris-(2-hydroxyethyl)ammonium |
| 308 | DCP | Ph | O | O | Dimethyl-(2-hydroxyethyl)ammonium |
| 309 | DCP | Ph | O | O | Benzyl-dimethyl-ammonium |
| 310 | DCP | Ph | O | O | Trimethylammonium |
| 311 | DCP | OEt | O | O | Cl |
| 312 | DCP | OEt | O | O | I |
| 313 | DCP | OEt | O | O | OCN |
| 314 | DCP | OEt | O | O | SCN |
| 315 | DCP | OEt | O | O | CN |
| 316 | DCP | OEt | O | O | Acetyloxy (-O(CO)CH₃) |
| 317 | DCP | OEt | O | O | Benzoyloxy (-O(CO)Ph) |
| 318 | DCP | OEt | O | O | Formyloxy (-O(CO)H) |
| 319 | DCP | OEt | O | O | Methoxycarbonyloxy (-O(CO)OCH₃) |
| 320 | DCP | OEt | O | O | Ethoxycarbonyloxy (-O(CO)OCH2CH₃) |
| 321 | DCP | OEt | O | O | n-Butoxycarbonyloxy (-O(CO)OCH₂CH₂CH₂CH₃) |
| 322 | DCP | OEt | O | O | Chlorcarbonyloxy (-O(CO)Cl) |
| 323 | DCP | OEt | O | O | Chlorsulfinyloxy (-O(SO)Cl) |
| 324 | DCP | OEt | O | O | Methoxysulfinyloxy (-O(SO)OCH₃) |
| 325 | DCP | OEt | O | O | Ethoxysulfinyloxy (-O(SO)OCH₂CH₃) |
| 326 | DCP | OEt | O | O | n-Butoxysulfinyloxy (-O(SO)OCH₂CH₂CH₂CH₃) |
| 327 | DCP | OEt | O | O | Chlorsulfuryloxy (-O(SO₂)Cl) |
| 328 | DCP | OEt | O | O | Methoxysulfuryloxy (-O(SO₂)OCH₃) |
| 329 | DCP | OEt | O | O | Ethoxysulfuryloxy (-O(SO₂)OCH₂CH₃) |
| 330 | DCP | OEt | O | O | Methylsulfonyloxy (-O(SO₂)CH₃) |
| 331 | DCP | OEt | O | O | Trifluormethylsulfonyloxy (-O(SO₂)CF₃) |
| 332 | DCP | OEt | O | O | Benzolsulfonyloxy (-O(SO₂)Ph) |
| 333 | DCP | OEt | O | O | p-Toluolsulfonyloxy (-O(SO₂)Ph-4-CH₃) |
| 334 | DCP | OEt | O | O | Dodecylbenzolsulfonyloxy |
| 335 | DCP | OEt | O | O | p-Brombenzolsulfonyloxy (-O(SO₂)Ph-4-Br) |
| 336 | DCP | OEt | O | O | Diethyl-(2-hydroxyethyl)ammonium |
| 337 | DCP | OEt | O | O | Benzyl-diethyl-ammonium |
| 338 | DCP | OEt | O | O | Tris-(2-hydroxyethyl)ammonium |
| 339 | DCP | OEt | O | O | Dimethyl-(2-hydroxyethyl)ammonium |
| 340 | DCP | OEt | O | O | Benzyl-dimethyl-ammonium |
| 341 | DCP | OEt | O | O | Trimethylammonium |
| 342 | DCP | TMB | O | O | Cl |
| 343 | DCP | TMB | O | O | I |
| 344 | DCP | TMB | O | O | OCN |
| 345 | DCP | TMB | O | O | SCN |
| 346 | DCP | TMB | O | O | CN |
| 347 | DCP | TMB | O | O | Acetyloxy (-O(CO)CH₃) |
| 348 | DCP | TMB | O | O | Benzoyloxy (-O(CO)Ph) |
| 349 | DCP | TMB | O | O | Formyloxy (-O(CO)H) |
| 350 | DCP | TMB | O | O | Methoxycarbonyloxy (-O(CO)OCH₃) |
| 351 | DCP | TMB | O | O | Ethoxycarbonyloxy (-O(CO)OCH₂CH₃) |
| 352 | DCP | TMB | O | O | n-Butoxycarbonyloxy (-O(CO)OCH₂CH₂CH₂CH₃) |
| 353 | DCP | TMB | O | O | Chlorcarbonyloxy (-O(CO)Cl) |
| 354 | DCP | TMB | O | O | Chlorsulfinyloxy (-O(SO)Cl) |
| 355 | DCP | TMB | O | O | Methoxysulfinyloxy (-O(SO)OCH₃) |
| 356 | DCP | TMB | O | O | Ethoxysulfinyloxy (-O(SO)OCH₂CH₃) |
| 357 | DCP | TMB | O | O | n-Butoxysulfinyloxy (-O(SO)OCH₂CH₂CH₂CH₃) |
| 358 | DCP | TMB | O | O | Chlorsulfuryloxy (-O(SO₂)Cl) |
| 359 | DCP | TMB | O | O | Methoxysulfuryloxy (-O(SO₂)OCH₃) |
| 360 | DCP | TMB | O | O | Ethoxysulfuryloxy (-O(SO₂)OCH₂CH₃) |
| 361 | DCP | TMB | O | O | Methylsulfonyloxy (-O(SO₂)CH₃) |
| 362 | DCP | TMB | O | O | Trifluormethylsulfonyloxy (-O(SO₂)CF₃) |
| 363 | DCP | TMB | O | O | Benzolsulfonyloxy (-O(SO₂)Ph) |
| 364 | DCP | TMB | O | O | p-Toluolsulfonyloxy (-O(SO₂)Ph-4-CH₃) |
| 365 | DCP | TMB | O | O | Dodecylbenzolsulfonyloxy |
| 366 | DCP | TMB | O | O | p-Brombenzolsulfonyloxy (-O(SO₂)Ph-4-Br) |
| 367 | DCP | TMB | O | O | Diethyl-(2-hydroxyethyl)ammonium |
| 368 | DCP | TMB | O | O | Benzyl-diethyl-ammonium |
| 369 | DCP | TMB | O | O | Tris-(2-hydroxyethyl)ammonium |
| 370 | DCP | TMB | O | O | Dimethyl-(2-hydroxyethyl)ammonium |
| 371 | DCP | TMB | O | O | Benzyl-dimethyl-ammonium |
| 372 | DCP | TMB | O | O | Trimethylammonium |

- DMP:: TMF: 2,4,6-Trimethyl-1-pnenyl 2,6-Dimethyl-1-phenyl
- DMOP:: 2,6-Dimethoxy-1-phenyl
- DCP:: 2,6-Dichlor-1-phenyl
- TMB:: 2,4,6-Trimethylbenzoyl
- Ph:: Phenyl
- EtO:: Ethoxy

Wie oben ausgeführt, sind auch solche Individuen aus der Tabelle bevorzugt, bei denen R² 4-Methylphenyl, 4-Methoxyphenyl, 4-Chlorphenyl, Methoxy, n-Propoxy, *iso*-Propoxy, n-Butoxy, *sek*-Butoxy, *iso*-Butoxy oder *tert*-Butoxy sind.

Wie oben ausgeführt, sind auch solche Individuen aus der Tabelle bevorzugt, bei denen R¹ ortho-substituiert sind, beispielsweise 2-Methylphenyl, 2-Methoxyphenyl oder 2-Chlorphenyl.

Die erfindungsgemäßen Acyl- und Bisacylphosphinderivate (I) können durch ein Verfahren hergestellt werden, in dem man einen Stoff der Formel (II) 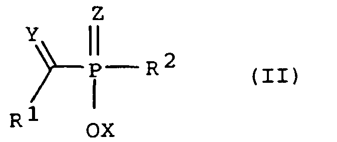 worin R¹, R², Y und z die oben genannte Bedeutung haben und
- X: Wasserstoff oder ein Kation ist,
mit mindestens einem Mittel umsetzt, das die Gruppe -OX in eine Gruppe -FG überführt.

Kationen können dabei beispielsweise solche sein, wie in der EP-A 62 839 aufgeführt, also Äquivalente eines Kations der 1. bis 3. Hauptgruppe des Periodensystems mit einem Molgewicht unter 138 oder Ammoniumionen, abgeleitet von quartären Ammoniumionen oder Triethylendiammoniumionen.

Mittel, die die Gruppe -OX in die Gruppe -FG überführen sind dem Fachmann an sich bekannt. Beispielhaft seien genannt Phosgen (COCl₂), Thionylchlorid (SOCl₂), Sulfurylchlorid (SO₂Cl₂), Phosphortrichlorid (PCl₃), Phosphoroxidtrichlorid (POCl₃), Phosphorpentachlorid (PCl₅), Oxalylchlorid ((COCl)₂), Chlorwasserstoff (HCl), Chlorgas (Cl₂), N-Chlorverbindungen, wie z.B. N-Chlorsuccinimid, Alkalifluoride, Cobalt(III)-fluorid, Halogenfluoride, Antimonfluoride, Molybdänfluorid, Fluorwasserstoff, Fluorwasserstoff/Pyridin-Gemische , Xenonfluoride und andere Edelgas-Verbindungen, gasförmiges Fluor, Schwefeltetrafluorid, Iod, Iodmonochlorid, Phosphortriiodid, Säureiodide, N-Iodsuccinimid, N-Iodacetamid, Chlorcyan (ClCN), Cyanurchlorid (2,4,6-Trichlor-1,3,5-triazin, C₃Cl₃N₃), Säurechloride (R⁵(CO)Cl), -ester oder -anhydride (R⁵(CO)O), Kohlensäurechloride (R⁵O(CO)Cl)), Carbonate ((R⁵O)₂(CO)), Sulfonsäurechloride (R⁵SO₂Cl) oder Sulfonsäureanhydride ((R⁵SO₂)₂O).

Soll ferner eine Verbindung mit FG = Br hergestellt werden, so können beispielsweise geeignete Mittel sein: Brom, Alkalimetallhypobromit, Bromiod, Bromcyan, PBr₃, PBr₅, POBr₃, SOBr₂, N-Bromsuccinimid, N-Bromacetamid und 1,3-Dibrom-5,5-dimethylhydantoin.

Enthält die Abgangsgruppe FG noch ein reaktives Zentrum, wie im Fall der Umsetzung mit Phosgen, Thionylchlorid, Sulfurylchlorid, Oxalylchlorid etc., so ist es möglich, dieses reaktive Zentrum nochmals umzusetzen, beispielsweise mit einem Alkohol R⁵OH, so daß Gruppen -(CO)Cl, -(SO)Cl, -(SO₂)Cl etc. in Gruppen -(CO)OR⁵, -(SO)OR⁵, -(SO₂)OR⁵ überführt werden.

Des weiteren ist es auch möglich, statt einer Gruppe -OX eine Gruppe -NH₂, -NHR⁶ oder -NR⁶R⁷ durch Quaternisierung in eine Gruppe -N⁺R⁶R⁷R⁸ zu überführen. Dies ist beispielsweise möglich durch Umsetzung mit Methylchlorid, Methylbromid, Methyliodid, Ethylchlorid, Ethylbromid, Ethyliodid, Benzylchlorid, Dimethylsulfat, Diethylsulfat, Dimethylcarbonat, Dibutylcarbonat, Ethylenoxid oder Propylenoxid.

Die Durchführung der Reaktion zur Überführung der Gruppe -OX in die Gruppe -FG mit den oben angegebenen Mittel ist dem Fachmann an sich bekannt und z.B. in Organikum - Organisch-chemisches Grundpraktikum, 17. Auflage, Berlin 1988, VEB Deutscher Verlag der Wissenschaften auf den Seiten 189 bis 191 (Thionylchlorid, Phosphorchloride und Iod/Phosphor) und 559 (p-Toluolsulfonsäureester) oder in Houben-Weyl, Methoden der Organischen Chemie, 4. Auflage, 1955, Thieme Verlag Stuttgart, Hrsg. Eugen Müller, Band 9, Seiten 663 bis 668 und 671 bis 673 (Sulfonsäureester) beschrieben.

Zur Umsetzung mit Thionylchlorid oder R⁵(SO)Cl wird meist in Gegenwart von 0,9 bis 1,5 Moläquivalenten eines Säurefängers, wie Pyridin oder ein tertiäres Amin, wie z.B. Triethylamin, Tributylamin, Benzyldimethylamin, Dimethylaminopyridin etc., bei Temperaturen zwischen 0 °C und 100 °C, bevorzugt zwischen 10 °C und 80 °C, das umzusetzende Substrat vorgelegt, gegebenenfalls gelöst in einem geeigneten Lösungsmittel, wie z.B. Benzol, Toluol, Xylol, Tetrahydrofuran, Hexan, Heptan, Pentan oder Petrolether, und das Mittel in einem Zeitraum von wenigen Minuten bis mehreren Stunden, bevorzugt 10 bis 300 Minuten, besonders bevorzugt 30 bis 180 Minuten unter kräftiger Durchmischung zugegeben. Gegebenenfalls kann nachgerührt werden, beispielsweise 30 bis 600 Minuten, bevorzugt 60 bis 300 Minuten, wobei die Reaktionstemperatur stufenweise langsam angehoben werden kann.

Das entstandene Reaktionsprodukt kann in roher oder aufgereinigter Form weiterverarbeitet werden.

Falls eine Weiterverwendung in reiner Form gewünscht wird, so kann das Produkt beispielsweise über Kristallisation und fest/ flüssig-Trennung oder über Destillation oder Rektifikation bei vermindertem Druck aufgereinigt werden.

Die Ausbeuten liegen in der Regel über 75 %, meist über 80 % und häufig über 90 %.

Für die Herstellung einer Gruppe FG = Cl wird bevorzugt Phosgen, Thionylchlorid oder Sulfurylchlorid verwendet, besonders bevorzugt Phosgen oder Thionylchlorid und insbesondere Thionylchlorid.

Für die Herstellung einer Gruppe FG = OSO₂R⁵ wird bevorzugt R⁵SO₂Cl oder (R⁵SO₂)₂O verwendet, besonders bevorzugt R⁵SO₂Cl.

Die Verbindungen der Formel (II) können erhalten werden, wie in EP-A 62 839 beschrieben: Ein beispielsweise wie eingangs erwähnt dargestellter Phosphinsäureester (III), bevorzugt ein Methyl-, Ethyl- oder n-Butylester, kann mit einem Metallhalogenid (MeHal), beispielsweise LiCl, LiBr, LiI, NaCl, NaBr, NaI, KCl, KBr oder KI, zur Verbindung (II), wobei X dem verwendeten Metall (Me) entspricht, umgesetzt werden. Ansäuern, z.B. mit Schwefelsäure, Salzsäure, Phosphorsäure, Salpetersäure oder Sulfonsäuren, oder Metallaustausch mit Ionentauschern führt zur Verbindung (II) mit X = H.

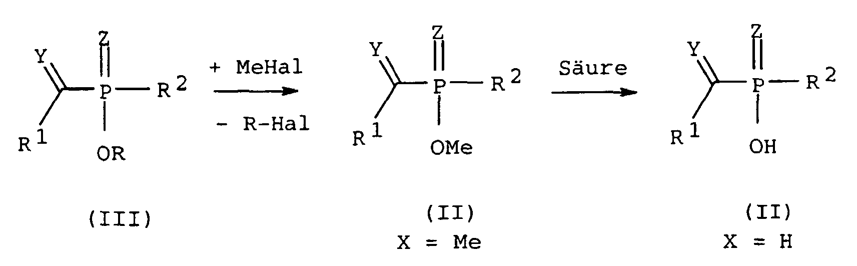

In neues Verfahren zur Herstellung von Verbindungen der Formel (II) mit X=H, in dem man Verbindungen der Formel (III) mit einem Halogenid umsetzt, das Bestandteil einer ionischen Flüssigkeit ist, wird hier beschrieben.

Als ionische Flüssigkeiten werden hier solche ionischen Verbindungen bezeichnet, die unter den Reaktionsbedingungen und/ oder Aufarbeitungsbedingungen flüssig sind. Die Schmelzpunkte der bevorzugten ionischen Flüssigkeiten liegen in der Regel unterhalb von 160 °C, besonders bevorzugt unterhalb von 100 °C und ganz besonders bevorzugt unterhalb von 80 °C.

In Formel (III) hat R die oben genannte Bedeutung für gegebenenfalls durch Aryl, Alkyl, Aryloxy, Alkyloxy, Heteroatome und/oder Heterocyclen substituiertes C₁ - C₁₈-Alkyl, bevorzugt handelt es sich um Methyl, Ethyl oder n-Butyl. R¹, R², Y und Z haben die oben genannten Bedeutungen.

Als Halogenide werden hier Fluorid, Chlorid, Bromid oder Iodid, bevorzugt Bromid oder Chlorid und besonders bevorzugt Chlorid verstanden.

Solche als Basen einsetzbaren Verbindungen können Phosphor-Schwefel oder Stickstoffatome enthalten, beispielsweise mindestens ein Stickstoffatom, bevorzugt ein bis zehn Stickstoffatome, besonders bevorzugt ein bis fünf, ganz besonders bevorzugt ein bis drei und insbesondere ein bis zwei Stickstoffatome. Gegebenenfalls können auch weitere Heteroatome, wie z.B. Sauerstoff-, Schwefel-, Phosphor- oder Halogenatome enthalten sein.

Bevorzugt sind solche Verbindungen, die mindestens einen fünfbis sechsgliedrigen Heterocyclus enthalten, der mindestens ein Stickstoffatom sowie gegebenenfalls ein Sauerstoff- oer Schwefelatom aufweist, besonders bevorzugt solche Verbindungen, die mindestens einen fünf- bis sechsgliedrigen Heterocyclus enthalten, der ein, zwei oder drei Stickstoffatome oder ein Stickstoff- und ein Sauerstoffatom aufweist, ganz besonders bevorzugt solche mit zwei Stickstoffatomen.

Besonders bevorzugte Verbindungen sind solche, die ein Molgewicht unter 1000 g/mol aufweisen, ganz besonders bevorzugt unter 500 g/ mol und insbesondere unter 250 g/mol.

Besonders bevorzugt sind Pyridine, Pyridazine, Pyrimidine, Pyrazine, Imidazole, 1H-Pyrazole, 3H-Pyrazole, 4H-Pyrazole, 1-Pyrazoline, 2-Pyrazoline, 3-Pyrazoline, Imidazoline, Thiazole, Oxazole, 1,2,4-Triazole oder 1,2,3-Triazole, unter diesen sind die Pyridine und die Imidazole bevorzugt.

Ganz besonders bevorzugt sind als Basen 3-Chlorpyridin, 4-Dimethylaminopyridin, 2-Ethyl-4-aminopyridin, 2-Methylpyridin, 2-Ethylpyridin, 2-Ethyl-6-methylpyridin, Chinolin, Isochinolin, Pyridin, 1-C₁-C₄-Alkylimidazol, 1-Methylimidazol, 1,2-Dimethylimidazol, 1-n-Butylimidazol, 1,4,5-Trimethylimidazol, 1,4-Dimethylimidazol, Imidazol, 2-Methylimidazol, 1-Butyl-2-methylimidazol, 4-Methylimidazol, 1-n-Pentylimidazol, 1-n-Hexylimidazol, 1-n-Octylimidazol, 1-(2'-Aminoethyl)-imidazol, 2-Ethyl-4-methylimidazol, 1-Vinylimidazol, 2-Ethylimidazol, 1-(2'-Cyanoethyl)-imidazol und Benzotriazol.

Insbesondere bevorzugt sind 1-n-Butylimidazol, 1-Methylimidazol, 2-Methylpyridin und 2-Ethylpyridin.

Dazu wird die Verbindung der Formel (III) mit einem in einer ionische Flüssigkeit gelösten Halogenid so umgesetzt, daß sich das Salz der genannten Base mit der Säure (III) mit X=H bildet.

Dies erfordert in der Regel Temperaturen von 40 - 160 °C, bevorzugt 50 - 150, besonders bevorzugt 60 - 140, ganz besonders bevorzugt 80 - 130 und insbesondere 90 - 120 °C.

Bevorzugt wird die Reaktion in Anwesenheit eines unter den Reaktionsbedingungen reaktionsträgen Gases durchgeführt, besonders bevorzugt wird dieses durch das Reaktionsgemisch geleitet.

In einer weiteren Ausführungsform wird ein leichter Unterdruck angelegt, beispielsweise 200 - 900 mbar, bevorzugt 300 - 800 mbar und besonders bevorzugt 500 - 750 mbar, um das Abtrennen des entstehenden Alkylhalogenids zu erleichtern.

Anschließend kann das Reaktionsgemisch mit Wasser verdünnt und die Säure (III) mit einer geeigneten starken Säure freigesetzt werden, beispielsweise Schwefelsäure, Salzsäure, Bromwasserstoffsäure, Salpetersäure, Ameisen- oder Essigsäure, bevorzugt mit der starken Säure, die die zu dem eingesetzten Halogenid korrespondierende ist.

Anschließend kann die Säure (III) mit X=H durch fest-flüssig oder flüssig-flüssig-Trennung abgetrennt und, falls erforderlich, weiter aufgereinigt werden.

Die erfindungsgemäßen Acyl- und Bisacylphosphinderivate können als Photoinitiatoren für die Strahlungshärtung von photopolymerisierbaren Massen verwendet werden, z.B. Überzugsmittel, Lacke, Druckfarben, Aufzeichnungsmaterialien, wäßrige Lösungen, Dispersionen und Emulsionen.

Die erfindungsgemäßen Photoinitiatoren können selbstverständlich auch im Gemisch mit anderen Photoinitiatoren verwendet werden. Dies können beispielsweise dem Fachmann bekannte Photoinitiatoren sein, z.B. solche in "Advances in Polymer Science", Volume 14, Springer Berlin 1974 oder in K. K. Dietliker, Chemistry and Technology of UV- and EB-Formulation for Coatings, Inks and Paints, Volume 3; Photoinitiators for Free Radical and Cationic Polymerization, P. K. T. Oldring (Eds), SITA Technology Ltd, London, genannten

In Betracht kommen z.B. Mono- oder Bisacylphosphinoxide, wie sie z.B. in EP-A 7 508, EP-A 57 474, DE-A 196 18 720, EP-A 495 751 oder EP-A 615 980 beschrieben sind, beispielsweise 2,4,6-Trimethylbenzoyldiphenylphosphinoxid (Lucirin^{®} TPO der BASF AG), Ethyl-2,4,6-trimethylbenzoylphenylphosphinat (Lucirin^{®} TPO L der BASF AG), Bis-(2,4,6-trimethylbenzoyl)-phenylphosphinoxid (Irgacure^{®} 819 der Firma Ciba Spezialitätenchemie), Benzophenone, Hydroxyacetophenone, Phenylglyoxylsäure und ihre Derivate oder Gemische dieser Photoinitiatoren. Als Beispiele seien genannt Benzophenon, Acetophenon, Acetonaphthochinon, Methylethylketon, Valerophenon, Hexanophenon, α-Phenylbutyrophenon, p-Morpholinopropiophenon, Dibenzosuberon, 4-Morpholinobenzophenon, 4-Morpholinodeoxybenzoin, p-Diacetylbenzol, 4-Aminobenzophenon, 4'-Methoxyacetophenon, β-Methylanthrachinon, *tert*-Butylanthrachinon, Anthrachinoncarbonysäureester, Benzaldehyd, α-Tetralon, 9-Acetylphenanthren, 2-Acetylphenanthren, 10-Thioxanthenon, 3-Acetylphenanthren, 3-Acetylindol, 9-Fluorenon, 1-Indanon, 1,3,4-Triacetylbenzol, Thioxanthen-9-on, Xanthen-9-on, 2,4-Dimethylthioxanthon, 2,4-Diethylthioxanthon, 2,4-Di-*iso*-propylthioxanthon, 2,4-Dichlorthioxanthon, Benzoin, Benzoin-*iso*-butylether, Chloroxanthenon, Benzoin-tetrahydropyranylether, Benzoin-methylether, Benzoinethylether, Benzoin-butylether, Benzoin-*iso*-propylether, 7-H-Benzoin-methylether, Benz[de]anthracen-7-on, 1-Naphthaldehyd, 4,4'-Bis(dimethylamino)benzophenon, 4-Phenylbenzophenon, 4-Chlorbenzophenon, Michlers Keton, 1-Acetonaphthon, 2-Acetonaphthon, 1-Benzoylcyclohexan-1-ol, 2-Hydroxy-2,2-dimethylacetophenon, 2,2-Dimethoxy-2-phenylacetophenon, 2,2-Diethoxy-2-phenylacetophenon, 1,1-Dichloracetophenon, 1-Hydroxyacetophenon, Acetophenondimethylketal, o-Methoxybenzophenon, Triphenylphosphin, Trio-Tolylphosphin, Benz[a]anthracen-7,12-dion, 2,2-Diethoxyacetophenon, Benzilketale, wie Benzildimethylketal, 2-Methyl-1-[4-(methylthio)phenyl]-2-morpholinopropan-1-on, Anthrachinone wie 2-Methylanthrachinon, 2-Ethylanthrachinon, 2-*tert*-Butylanthrachinon, 1-Chloranthrachinon, 2-Amylanthrachinon und 2,3-Butandion.

Geeignet sind auch nicht- oder wenig vergilbende Photoinitiatoren vom Phenylglyoxalsäureestertyp, wie in DE-A 198 26 712, DE-A 199 13 353 oder WO 98/33761 beschrieben.

Die erfindungsgemäßen Acyl- und Bisacylphosphinderivate gemäß Formel (I) beziehungsweise die nach dem erfindungsgemäßen Verfahren hergestellten Verbindungen eignen sich in besonderer Weise als Ausgangsverbindungen für die Herstellung neuer Photoinitiatoren, wie z.B. solcher, die in den deutschen Patentanmeldungen mit dem Titel "Alkoxylierte Mono- und Bisacylphosphinderivate" und dem Aktenzeichen 102 06 097.5 sowie dem Titel "Mono- und Bisacylphosphinderivate" und dem Aktenzeichen 102 06 096.7 mit dem Anmeldetag 13. Februar 2002.

Bevorzugt ist die Umsetzung der erfindungsgemäßen Acyl- und Bisacylphosphinderivate gemäß Formel (I) mit Verbindungen, die selber eine (co)polymerisierbare Gruppe tragen und zusätzlich eine Gruppe, die zur Reaktion mit den erfindungsgemäßen Stoffen gemäß Formel (I) befähigt ist.

Durch die Abgangsgruppe FG können die erfindungsgemäßen Verbindungen (I) mit solchen Verbindungen chemisch gekoppelt werden, die beispielsweise freie Hydroxy-, Amino-, Monoalkylamino-, Monoarylamino- und/oder Mercaptogruppen enthalten. Dies können bevorzugt solche Verbindungen sein, die selber polymerisierbare Verbindungen sind, also mindestens eine (co)polymerisierbare Gruppe tragen, oder solche Verbindungen, die eine als Photoinitiator wirksame Gruppe, wie z.B. Acylphosphinoxide, Bisacylphosphinoxide, Benzophenone, Acetophenone oder Phenylglyoxylsäureester tragen, oder solche, die reaktive Gruppen tragen, die ihrerseits mit einem Polymer wechselwirken können.

Besonders bevorzugt ist die Umsetzung mit Verbindungen, die mindestens eine (co)polymerisierbare Gruppe tragen.

(Co)polymerisierbare Gruppen können solche sein, die ungesättigte Bindungen aufweisen, bevorzugt Kohlenstoff-Kohlenstoff-Doppelbindungen.

Dies können beispielsweise radikalisch oder kationisch polymerisierbare Gruppen sein.

Radikalisch (co)polymerisierbare Gruppen sind beispielsweise isolierte ethylenisch ungesättigte Gruppen, konjugierte ungesättigte Gruppen, vinylaromatische Gruppen, vinyl- und vinylidenchloridische Gruppen, N-Vinylamide, Vinylpyrrolidone, Vinyllactame, Vinylester, (Meth)acrylester oder Acrylnitrile.

Kationisch (co)polymerisierbare Gruppen sind beispielsweise Isobutyleneinheiten oder Vinylether.

Solche Verbindungen, die mit den erfindungsgemäßen Acyl- und Bisacylphosphinderivaten (I) umgesetzt werden können, können z.B. Monoester von α,β-ungesättigten Carbonsäuren, wie Acrylsäure, Methacrylsäure (in dieser Schrift kurz als "(Meth)acrylsäure" bezeichnet), Crotonsäure, Itaconsäure, Fumarsäure, Maleinsäure, Acrylamidoglykolsäure, Methacrylamidoglykolsäure oder Vinylether mit Di- oder Polyolen sein, die vorzugsweise 2 bis 20 C-Atome und wenigstens zwei Hydroxylgruppen aufweisen, wie Ethylenglykol, Diethylenglykol, Triethylenglykol, 1,2-Propylenglykol, 1,3-Propylenglykol, 1,1-Dimethyl-1,2-Ethandiol, Dipropylenglykol, Triethylenglykol, Tetraethylenglykol, Pentaethylenglykol, Tripropylenglykol, 1,4-Butandiol, 1,5-Pentandiol, Neopentylglykol, 1,6-Hexandiol, 2-Methyl-1,5-pentandiol, 2-Ethyl-1,4-butandiol, 1,4-Dimethylolcyclohexan, Glycerin, Trimethylolethan, Trimethylolpropan, Trimethylolbutan, Pentaerythrit, Ditrimethylolpropan, Erythrit, Sorbit, Poly-THF mit einem Molgewicht zwischen 162 und 2000, Poly-1,3-propandiol mit einem Molgewicht zwischen 134 und 400 oder Polyethylenglykol mit einem Molgewicht zwischen 238 und 458. Weiterhin können auch Ester oder Amide der (Meth)acrylsäure mit Aminoalkoholen z. B. 2-Aminoethanol, 2-(Methylamino)ethanol, 3-Amino-1-propanol, 1-Amino-2-propanol oder 2-(2-Aminoethoxy)ethanol, 2-Mercaptoethanol oder Polyaminoalkane, wie Ethylendiamin oder Diethylentriamin, oder Vinylessigsäure verwendet werden.

Weiterhin sind auch ungesättigte Polyether- oder Polyesterole oder Polyacrylatpolyole mit einer mittleren OH-Funktionalität von 2 bis 10 geeignet, die bevorzugt ein Molgewicht von 200 bis 2000 aufweisen.

Beispiele für Amide ethylenisch ungesättigter Carbonsäuren mit Aminoalkoholen sind Hydroxyalkyl(meth)acrylamide wie N-Hydroxymethylacrylamid, N-Hydroxymethylmethacrylamid, N-Hydroxyethylacrylamid, N-Hydroyxethylmethacrylamid, 5-Hydroxy-3-oxa-pentyl(meth)acrylamid, N-Hydroxyalkylcrotonamide wie N-Hydroxymethylcrotonamid oder N-Hydroxyalkylmaleinimide wie N-Hydroxyethylmaleinimid.

Bevorzugt für die Umsetzung mit (I) verwendet werden 2-Hydroxyethyl(meth)acrylat, 2- oder 3-Hydroxypropyl(meth)acrylat, 1,4-Butandiolmono(meth)acrylat, Neopentylglykolmono(meth)acrylat, Glycerinmono- und di(meth)acrylat, Trimethylolpropanmono- und di(meth)acrylat, Pentaerythritmono-, -di- und -tri(meth)acrylat sowie 4-Hydroxybutylvinylether, 2-Aminoethyl(meth)acrylat, 2-Aminopropyl(meth)acrylat, 3-Aminopropyl(meth)acrylat, 4-Aminobutyl(meth)acrylat, 6-Aminohexyl(meth)acrylat, 2-Thioethyl(meth)acrylat, 2-Aminoethyl(meth)acrylamid, 2-Aminopropyl(meth)acrylamid, 3-Aminopropyl(meth)acrylamid, 2-Hydroxyethyl(meth)acrylamid, 2-Hydroxypropyl(meth)acrylamid oder 3-Hydroxypropyl(meth)acrylamid. Besonders bevorzugt sind 2-Hydroxyethylacrylat, 2-Hydroxyethylmethacrylat, 2- oder 3-Hydroxypropylacrylat, 1,4-Butandiolmonoacrylat und 3-(Acryloxy)-2-hydroxypropylmethacrylat.

Auf diesem Wege sind Verbindungen herstellbar, die durch die polymerisierbaren Gruppen bei einer Polymerisation in das Polymerisat eingebaut werden können, die andererseits aber auch als Photoinitiatoren wirken, was die Migrationsfähigkeit der Photoinitiatoren deutlich herabsetzt.

Die erfindungsgemäßen Acyl- und Bisacylphosphinderivate gemäß Formel (I) zeigen auch ohne Umsetzung mit Verbindungen mit polymerisierbaren Gruppen eine im allgemeinen geringere Migrationstendenz als die meisten herkömmlichen Acylphosphinoxidverbindungen, da sie durch ihre reaktive Gruppe FG mit reaktiven Zentren in den Komponenten, die die strahlungshärtbaren Massen bilden, zu reagieren vermögen, so daß die erfindungsgemäßen Verbindungen beispielsweise an das Bindemittel der strahlungszuhärtenden Zusammensetzungen unter Ausbildung einer chemischen Bindung gebunden werden können.

Als reaktive Zentren in strahlungshärtbaren Zusammensetzungen oder Massen vermögen beispielsweise freie Hydroxy-, Amino-, Monoalkylamino-, Monoarylamino- und/oder Mercaptogruppen fungieren.

Gegenstand der Erfindung sind demzufolge auch strahlungshärtbare Zusammensetzungen, die durch Umsetzung mindestens eines Acyl- und Bisacylphosphinderivates gemäß Formel (I) oder hergestellt nach dem erfindungsgemäßen Verfahren mit einer freie Hydroxy-, Amino-, Monoalkylamino-, Monoarylamino- und/oder Mercaptogruppen enthaltenden strahlungshärtbaren Zusammensetzung erhältlich sind.

Geeignete strahlungshärtbare Zusammensetzungen enthalten beispielsweise mindestens eine polymerisierbare Verbindung mit einer oder mehreren (co)polymerisierbaren, ethylenisch ungesättigten Gruppen und einem oder mehreren reaktiven Zentren.

Dies können beispielsweise reaktive Zentren enthaltende Urethan-, Melamin-, Polyesterol-, Polyetherol-, Epoxid- oder Carbonatacrylate, -methacrylate oder -vinylether sein.

Die Herstellung solcher Urethan-, Melamin-, Polyesterol-, Polyetherol-, Epoxid- oder Carbonatacrylate, -methacrylate oder - vinylether ist dem Fachmann an sich bekannt. Die Anzahl an reaktiven Zentren und ethylenisch ungesättigten Gruppen ist durch geeignete Mischung der einzelnen Komponenten einstellbar.

Das zahlenmittlere Molekulargewicht Mₙ der einsetzbaren polymerisierbaren Verbindungen ist nicht beschränkt. Es kann beispielsweise unter 20000 liegen, bevorzugt unter 15000, besonders bevorzugt unter 10000 und insbesondere unter 6000.

Die Polydispersität M_{w}/Mₙ, der Quotient aus dem zahlenmittleren und dem gewichtsmittleren Molekulargewicht der polymerisierbaren Verbindungen, stellt ein Maß für die Molekulargewichtsverteilung der polymerisierbaren Verbindungen dar und hat im Idealfall den Wert 1, jedoch genügen für die Praxis auch Werte unter 4,0, insbesondere unter 3,5.

Die Angaben zur Polydispersität sowie zum zahlenmittleren und gewichtsmittleren Molekulargewicht Mₙ und M_{w} beziehen sich hier auf gelpermeationschromatographische Messungen, wobei Polystyrol als Standard und Tetrahydrofuran als Elutionsmittel verwendet wurde. Die Methode ist im Analytiker Taschenbuch Bd. 4, Seiten 433 bis 442 , Berlin 1984 beschrieben.

Die erfindungsgemäßen Verbindungen der Formel (I) reagieren nach Vermischen mit der strahlungshärtbaren Zusammensetzung mit deren reaktiven Zentren und werden so migrationsfest gebunden.

Die mit den erfindungsgemäßen, einbaubaren Photoinitiatoren hergestellten Beschichtungsmassen eignen sich besonders zur Verwendung in Verpackungssystemen, besonders bevorzugt im Lebensmittelbereich.

Bevorzugt sind solche Zusammensetzungen, die von 0,005 bis 0,5, besonders bevorzugt 0,01 - 0,3, ganz besonders bevorzugt 0,05 -0,2 und insbesondere 0,07 - 0,15 mol Hydroxylgruppen pro 100 g Substanz aufweisen.

Üblicherweise werden pro 1 mol Hydroxygruppen in der strahlungshärtbaren Zusammensetzung zwischen 0,05 und 1,0 mol der erfindungsgemäßen Acyl- und Bisacylphosphinderivate der Formel (I) eingesetzt, bevorzugt 0,1 bis 0,9 mol, besonders bevorzugt 0,2 bis 0,8, ganz besonders bevorzugt 0,25 bis 0,75 mol und insbesondere 0,3 bis 0,5 mol.

Die Bindung der erfindungsgemäßen Verbindungen der Formel (I) an die reaktiven Zentren erfolgt in der Regel bei einer Temperatur zwischen Raumtemperatur und der Härtungstemperatur der so erhältlichen strahlungshärtbaren Masse. Typische Temperaturen liegen bei 40 - 120 °C, bevorzugt 50 - 110 °C und besonders bevorzugt 60 - 100 °C.

Im Verlauf des Härtungs- beziehungsweise Bindungsprozesses kann die Temperatur gleichbleiben oder angehoben werden.

Die Dauer der thermischen Behandlung liegt in der Regel zwischen wenigen Minuten und mehreren Stunden, beispielsweise von 1 Minute bis 5 Stunden, bevorzugt 2 Minuten bis 3 Stunden, besonders bevorzugt 5 Minuten bis 2 Stunden und insbesondere von 10 Minuten bis 1 Stunde.

Weiterhin wurde gefunden, daß im Stand der Technik bekannte Verbindungen der generischen Formel (I') als Photoinitiatoren verwendet werden können, die der Formel (I) entsprechen, jedoch eine andere Gruppe FG aufweisen.

FG in Formel (I') hat folgende Bedeutungen:
FG -Br, -(NR³)-NR⁴R9, -(NR³)-OR⁹ oder -SR³ (für Z=S) und
- R⁹: Wasserstoff oder C₁ bis C₄-Alkyl,
wobei R³ und R⁴ die oben genannten Bedeutungen haben.

Bevorzugt werden solche Verbindungen als Photoinitiatoren verwendet, bei denen FG = Br oder -SR³ bedeutet.

Strahlungshärtbare Massen enthalten typischerweise

| | |
|---|---|
| (A) | mindestens eine polymerisierbare Verbindung mit einer oder mehreren copolymerisierbaren, ethylenisch ungesättigten Gruppen, |
| | |
| (B) | gegebenenfalls Reaktivverdünner, |
| | |
| (C) | mindestens einen erfindungsgemäßen Photoinitiator und gegebenenfalls mindestens einen weiteren an sich bekannten Photoinitiator sowie |
| | |
| (D) | gegebenenfalls weitere lacktypische Additive. |

Typische Zusammensetzungen sind beispielsweise

| | |
|---|---|
| (A) | 40 - 100 Gew%, bevorzugt 50 - 90, besonders bevorzugt 60 - 90 und insbesondere 60 - 80 Gew%, |
| | |
| (B) | 0 - 60 Gew%, bevorzugt 5 - 50, besonders bevorzugt 6 - 40 und insbesondere 10 - 30 Gew%, |
| | |
| (C) | 0,1 - 20 Gew%, bevorzugt 0,5 - 15, besonders bevorzugt 1 - 10 und insbesondere 2 - 5 Gew% sowie |
| | |
| (D) | 0 - 50 Gew%, bevorzugt 2 - 40, besonders bevorzugt 3 - 30 und insbesondere 5 - 20 Gew% , |

mit der Maßgabe, daß die Summe immer 100 Gew% beträgt.

In speziellen Anwendungen kann der Anteil an lacktypischen Additiven (D) bis zu 90 Gew% betragen, in diesem Fall verringern sich die Anteile der anderen Komponenten entsprechend.

Verbindungen (A) können beispielsweise die oben aufgeführten Urethan-, Melamin-, Polyesterol-, Polyetherol-, Epoxid- oder Carbonatacrylate, -methacrylate oder -vinylether sein.

Bevorzugt handelt es sich bei Verbindungen (A) um Vinylether- oder (Meth)acrylatverbindungen, besonders bevorzugt sind jeweils die Acrylatverbindungen, d.h. die Derivate der Acrylsäure.

Bevorzugte Vinylether- und (Meth)acrylat-Verbindungen (A) enthalten 2 bis 20, bevorzugt 2 bis 10 und ganz besonders bevorzugt 2 bis 6 copolymerisierbare, ethylenisch ungesättigte Doppelbindungen.

Besonders bevorzugt sind solche Verbindungen (A) mit einem Gehalt an ethylenisch ungesättigte Doppelbindungen von 0,1 - 0,7 mol /100 g, ganz besonders bevorzugt 0,2 - 0,6 mol / 100 g.

Als Reaktivverdünner (Verbindungen (B)) kommen radikalisch polymerisierbare Verbindungen, bevorzugt strahlungshärtbare, mit einer ethylenisch ungesättigten, copolymerisierbaren Gruppe in Betracht, oder Gemische davon.

Genannt seien z.B. α,β-ungesättigte Carbonsäuren, C₁-C₂₀-Alkyl(meth)acrylate, Vinylaromaten mit bis zu 20 C-Atomen, Vinylester von bis zu 20 C-Atomen enthaltenden Carbonsäuren, ethylenisch ungesättigte Nitrile, Vinylether von 1 bis 10 C-Atome enthaltenden Alkoholen und aliphatischen Kohlenwasserstoffen mit 2 bis 8 C-Atomen und 1 oder 2 Doppelbindungen.

Der Begriff (Meth)acrylsäure wird im Rahmen dieser Schrift für Acrylsäure und Methacrylsäure verwendet.

Als α,β-ungesättigte Carbonsäuren können beispielsweise Acrylsäure, Methacrylsäure, Maleinsäure oder deren Halbester, 3-Acryloxypropionsäure, Maleinsäureanhydrid, Fumarsäure oder deren Halbester oder Crotonsäure verwendet werden.

Als (Meth)acrylsäurealkylester bevorzugt sind solche mit einem C₁-C₁₀-Alkylrest, wie Methylmethacrylat, Methylacrylat und Ethylacrylat.

Insbesondere sind auch Mischungen der (Meth)acrylsäurealkylester geeignet.

Vinylester von Carbonsäuren mit 1 bis 20 C-Atomen sind z.B. Vinyllaurat, Vinylstearat, Vinylpropionat und Vinylacetat.

Als vinylaromatische Verbindungen kommen z.B. Vinyltoluol, α-Butylstyrol, 4-n-Butylstyrol, 4-n-Decylstyrol und vorzugsweise Styrol in Betracht.

Beispiele für Nitrile sind Acrylnitril und Methacrylnitril.

Geeignete Vinylether sind z.B. Vinylmethylether, Vinylisobutylether, Vinylhexylether und Vinyloctylether.

Als nicht aromatische Kohlenwasserstoffe mit 2 bis 8 C-Atomen und einer oder zwei olefinischen Doppelbindungen seien Butadien, Isopren, sowie Ethylen, Propylen und Isobutylen genannt.

Weiterhin sind N-Vinylformamid, N-Vinylpyrrolidon sowie N-Vinylcaprolactam einsetzbar.

Als lacktypische Additive (D) können beispielsweise Antioxidantien, Oxidationsinhibitoren, Stabilisatoren, Aktivatoren (Beschleuniger), Füllmittel, Pigmente, Farbstoffe, Entgasungsmittel, Glanzmittel, antistatische Agentien, Flammschutzmittel, Verdicker, thixotrope Agentien, Verlaufshilfsmittel, Bindemittel, Antischaummittel, Duftstoffe, oberflächenaktive Agentien, Viskositätsmodifikatoren, Weichmacher, Plastifizierer, klebrigmachende Harze (Tackifier), Chelatbildner oder Verträglichkeitsmittel (compatibilizer) verwendet werden.

Die Beschichtung von Substraten mit den strahlungshärtbaren Massen erfolgt nach üblichen, dem Fachmann bekannten Verfahren, wobei man wenigstens eine erfindungsgemäße strahlungshärtbare Zusammensetzung, beispielsweise in Form einer Dispersion oder auch ohne Lösungsmittel, auf das zu beschichtende Substrat in der gewünschten Stärke aufbringt und die flüchtigen Bestandteile der Dispersion, gegebenenfalls unter Erhitzen, entfernt. Dieser Vorgang kann gewünschtenfalls ein- oder mehrfach wiederholt werden.

Das Aufbringen auf das Substrat kann in bekannter Weise, z. B. durch Spritzen, Sprühen, Eintauchen, Spachteln, Rakeln, Airblade, Bürsten, Rollen, Walzen oder Gießen erfolgen. Die Beschichtungsstärke liegt in der Regel in einem Bereich von etwa 3 bis 1000 g/m² und vorzugsweise 10 bis 200 g/m².

Weiterhin wird ein Verfahren zum Beschichten von Substraten offenbart, bei dem man eine Beschichtungsmasse, enthaltend einen erfindungsgemäßen Stoff, gegebenenfalls als Lackformulierung mit weiteren lacktypischen Additiven und/oder thermisch härtbaren Harzen versetzt, auf das Substrat aufbringt, gegebenenfalls trocknet, bei der oben angegebenen Härtungstemperatur thermisch behandelt und anschließend, gegebenenfalls bei Temperaturen bis zur Höhe der Härtungstemperatur, mit aktiver Strahlung unter sauerstoffhaltiger Atmosphäre, wie z.B. Luft, oder bevorzugt unter Inertgas härtet.

Das Verfahren zum Beschichten von Substraten kann auch so durchgeführt werden, daß nach dem Aufbringen der erfindungsgemäßen Mischung oder Lackformulierung zunächst mit aktiver Strahlung unter sauerstoffhaltiger Atmosphäre, z.B. Luft, oder bevorzugt unter Inertgas gehärtet und anschließend bei der Härtungstemperatur thermisch behandelt wird.

Thermische und Strahlungshärtung kann selbstverständlich auch parallel erfolgen.

Die Härtung der auf dem Substrat gebildeten Filme kann gewünschtenfalls ausschließlich thermisch erfolgen. Im allgemeinen härtet man die Beschichtungen jedoch sowohl durch Bestrahlung mit energiereicher Strahlung als auch thermisch.

Gegebenenfalls kann, wenn mehrere Schichten des Beschichtungsmittels übereinander aufgetragen werden, nach jedem Beschichtungsvorgang eine thermische und/oder Strahlungshärtung erfolgen.

Beispiele für aktive Energiestrahlen sind ultraviolette, Röntgen- und Elektronenstrahlen, bevorzugt sind ultraviolette und Elektronenstrahlen.

Weiterhin kann die Beschichtung von Substraten, auch wie folgt erfolgen, wobei man
i) ein Substrat mit einer erfindungsgemäßen Mischung, wie zuvor beschrieben, beschichtet,
ii) flüchtige Bestandteile der erfindungsgemäßen Mischung zur Filmbildung unter Bedingungen entfernt, bei denen der Initiator (C) im wesentlichen noch keine freien Radikale ausbildet,
iii)gegebenenfalls den in Schritt ii) gebildeten Film mit energiereicher Strahlung bestrahlt, wobei der Film vorgehärtet wird, und anschließend gegebenenfalls den mit dem vorgehärteten Film beschichteten Gegenstand mechanisch bearbeitet oder die Oberfläche des vorgehärteten Films mit einem anderen Substrat in Kontakt bringt,
iv) den Film thermisch endhärtet

Dabei können die Schritte iv) und iii) auch in umgekehrter Reihenfolge durchgeführt, d. h. der Film kann zuerst thermisch und dann mit energiereicher Strahlung gehärtet werden.

Typische Härtungstemperaturen liegen bei 40 - 120 °C, bevorzugt 50 - 110 °C und besonders bevorzugt 60 - 100 °C.

Im Verlauf des Härtungsprozesses kann die Temperatur gleichbleiben oder angehoben werden.

Die Härtungsdauer liegt in der Regel zwischen wenigen Minuten und mehreren Stunden, beispielsweise von 1 Minute bis 5 Stunden, bevorzugt 2 Minuten bis 3 Stunden, besonders bevorzugt 5 Minuten bis 2 Stunden und insbesondere von 10 Minuten bis 1 Stunde.

Als Strahlungsquellen für die Strahlungshärtung geeignet sind z.B. Quecksilber-Niederdruckstrahler, -Mitteldruckstrahler mit Hochdruckstrahler sowie Leuchtstoffröhren, Impulsstrahler, Metallhalogenidstrahler, Xenonlampen, elektrodenlose Entladungslampen, Kohlebogenlampen, Elektronenblitzeinrichtungen, wodurch eine Strahlungshärtung ohne Photoinitiator möglich ist, oder Excimerstrahler. Die Strahlungshärtung erfolgt durch Einwirkung energiereicher Strahlung, also W-Strahlung oder Tageslicht, vorzugsweise Licht im Wellenlängenbereich von λ=150 bis 700 nm, besonders bevorzugt von λ=200 bis 500 nm und ganz besonders bevorzugt λ=250 bis 400 nm, oder durch Bestrahlung mit energiereichen Elektronen (Elektronenstrahlung; 50 bis 1000 keV, bevorzugt 100 bis 500 und besonders bevorzugt 150 bis 300 keV) mit Vorrichtungen z.B. vom Cockroft-Walton-Typ, van-de-Graaff-Typ oder Resonanztyp. Als Strahlungsquellen dienen beispielsweise Hochdruckquecksilberdampflampen, Laser, gepulste Lampen (Blitzlicht), Halogenlampen oder Excimerstrahler. Die üblicherweise zur Vernetzung ausreichende Strahlungsdosis bei UV-Härtung liegt im Bereich von 80 bis 3000 mJ/cm².

Selbstverständlich sind auch mehrere Strahlungsquellen für die Härtung einsetzbar, z.B. zwei bis vier.

Diese können auch in jeweils unterschiedlichen Wellenlängebereichen strahlen.

Da der Chromophor des Acylphosphinoxids eine Absorptionsbande im sichtbaren Wellenlängenbereich oberhalb 400 nm aufweist, können die erfindungsgemäßen Photoinitiatoren auch mit einer Strahlungsquelle mit einem geringen oder auch keinem UV-Anteil eingesetzt werden. Eine Tageslichthärtung ist ebenfalls möglich, wenn auch in der Regel langsamer als eine Härtung mit aktiven Energiestrahlen.

So entspricht beispielsweise das Absorptionsspektrum der Verbindung I-1 im wesentlichen dem des Lucirin TPO, wobei entscheidend ist, daß sich der Absorptionsbereich in den Bereich sichtbaren Lichts erstreckt.

Die Bestrahlung kann gegebenenfalls auch unter Ausschluß von Sauerstoff, z. B. unter Inertgas-Atmosphäre, durchgeführt werden. Als Inertgase eignen sich vorzugsweise Stickstoff, Edelgase, Kohlendioxid, oder Verbrennungsgase. Desweiteren kann die Bestrahlung erfolgen, indem die Beschichtungsmasse mit transparenten Medien abgedeckt wird. Transparente Medien sind z. B. Kunststofffolien, Glas oder Flüssigkeiten, z. B. Wasser. Besonders bevorzugt ist eine Bestrahlung in der Weise, wie sie in der DE-A 199 57 900 beschrieben ist.

Die folgenden Beispiele sollen die Eigenschaften der Erfindung erläutern, ohne sie aber einzuschränken.

### Beispiele

Als "Teile" seien in dieser Schrift, wenn nicht anders angegeben, "Gewichtsteile" verstanden.

### Beispiel 1

### Trimethylbenzoylphenylphosphinsäure-Natriumsalz

644 g Trimethylbenzoylphenylphosphinsäureethylester, (Lucirin® TPO-L der BASF AG) wurde in 3000 ml Ethylmethylketon vorgelegt und zu der Lösung 1,1 Äquivalente (285 g) Natriumiodid hinzugegeben. Nach 15 min wurde die homogene Lösung auf 65 °C erhitzt und 24 h gerührt. Der gelbe Niederschlag wurde abgesaugt und mit 2x500 ml Petrolether gewaschen. Der Nutschkuchen wurde im Vakuum bei 60°C getrocknet. Man isolierte 530 g (85 % der Theorie) hellgelbes Pulver.
³¹P-NMR (d₆-DMSO): δ (ppm) =10.8
¹H-NMR (d₆-DMSO): δ (ppm) = 2.2 (s, 6H), 2.25 (s, 3H), 6.6 (s, 2H), 7.3 (m, 3H), 7.6 (m, 2H)

### Beispiel 2

### Trimethylbenzoylphenylphosphinsäure

401,55 g Natriumsalz aus Beispiel 1 wurde in 1500 ml Wasser gelöst mit 1300 ml 0,5 molarer Schwefelsäure bis der pH 1 angesäuert. Nach 1 h wurde der ausgefallene Kristallbrei abgesaugt, 2 x mit je 700 ml Wasser gewaschen und trockengesaugt. Der Nutschkuchen wurde mit 1500 ml Toluol im Wasserauskreiser azeotrop getrocknet. Die klare hellgelbe toluolische Lösung wurde bei 50°C eingeengt und die Säure aus 2150 ml Essigester umkristallisiert. Die Kristalle wurden bei 0° abgesaugt, mit Essigester gewaschen und im Vakuum bei 60 °C getrocknet. Auswaage: 300 g (80 % der Theorie) hellgelbe Kristalle.
³¹P-NMR (d₆-DMSO): δ (ppm) = 17.4
¹H-NMR (d₆-DMSO): δ (ppm) = 2.1 (s, 6H), 2.3 (s, 3H), 6.7 (s, 2H), 7.35 (m, 2H), 7.6 (m, 1H), 7.75 (m, 2H)

### Beispiel 3

### Trimethylbenzoylphenylphosphinsäurechlorid

250 g der Säure aus Beispiel 2 wurde in 670 Toluol suspendiert und mit 102,6 g Pyridin gelöst. Zu dem Reaktionsgemisch wurde bei 60 °C innerhalb von 1 h 1546 g Thionylchlorid zugetropft. Nach 3 h Nachreaktionszeit wurde die rotbraune Emulsion auf 0 °C abgekühlt und die rostbraunen Kristalle abfiltriert. Die verbleibende Lösung wurde im Vakuum eingeengt.
Auswaage: 265 g (91 % der Theorie).
³¹P-NMR (d₆-DMSO) : δ (ppm) = 28,4
¹H-NMR (d₆-DMSO): δ (ppm) = 1.7 (s, 6H), 1.8 (s, 3H), 6.4 (s, 2H; Mesityl-CH), 7.15 (m, 2H), 7.25 (m, 1H), 7.55 (m, 2H)

### Beispiel 4

### Umsetzung mit Hydroxyethylacrylat

Eine Lösung aus 100 ml Toluol, 7,34 g Triethylamin und 19,07 g des Chlorids aus Beispiel 3 wurde unter Stickstoffatmosphäre auf 50 °C erwärmt. Innerhalb von 30 min wurden 6,01 g Hydroxyethylacrylat portionsweise zudosiert. Die Temperatur stieg bis auf 60 °C an. Nach weiteren zwei Stunden bei 50 °C wurde das Reaktionsgemisch auf Raumtemperatur abgekühlt und mit 20 ml vollentsalztem Wasser versetzt. Die organische Phase wurde dreimal mit je 30 ml gesättigter Kochsalzlösung extrahiert. Die über Natriumsulfat getrocknete organische Phase wurde zur Trockne eingeengt. Man erhielt 18,52 g des Produktes als bräunliches Öl.

Reingehalt 98 % (lt HPLC, Retentionszeit 7 min, HPLC-Analytik: Kontron Instruments HPLC-Pump 422, Lichrosorb 18 7, Bischoff Chromatography, Shimadzu C-R6A Chromatopac, Mitlon Roy Spectro Monitor 3100 (230 nm), Acetonitril/Wasser/Phosphorsäure (Verhältnis 570:430:1) bei 1.1 ml/min.); Ausbeute 91 % d. Theorie, Reinheit lt. ³¹P-NMR 100 %.

### Beispiel 5

### Herstellung von Trimethylbenzoylphenylphosphinsäure

In einem 2 1 Rührkolben mit Innenthermometer und Kühler wurden 17 g LiCl in 250 ml Dimethylformamid gelöst. Anschließend wurde eine Lösung von 86 g Trimethylbenzoylphenylphosphinsäureethylester in 50 ml DMF innerhalb einer Stunde zugetropft. Die Reaktionsmischung rührte man anschließend über Nacht bei 65°C. In das Gemisch tropfte man 850 ml Eiswasser, worauf eine leicht trübe Lösung erhalten wurde. Nach Aufwärmen auf 35°C gab man 450 ml 0,5 M H2S04 zu, bis ein pH von 1,5-2 erreicht wurde, wobei farblose Kristalle ausfielen. Es wurde eine Stunde bei 5°C nachgerührt. Die Kristalle wurden abfiltriert und zweimal mit je 200 ml Wasser gewaschen. Nach Trocknen wurden 71,7 g 98%ige Trimethylbenzoylphenylphosphinsäure (HPLC) erhalten.

### Beispiel 6

### Herstellung von Trimethylbenzoylphenylphosphinsäure

Unter Stickstoffatmosphäre wurden 10 g Trimethylbenzoylphenylphosphinsäureethylester und 3,75 g 1-Methylimidazol-Hydrochlorid in einem 250-ml-Vierhalskolben mit Teflonblattrührer und Kühler vereinigt und 5,5 h bei 110 °C gerührt. Anschließend wurde die Heizquelle entfernt, 100 ml Eiswasser unter kräftigem Rühren zugetropft und 10 min nachgerührt. Dabei bildete sich eine organische-wäßrige Emulsion, die bei ca. 50 °C unter kräftigem Rühren mit 35 ml 0.5-molarer Schwefelsäure auf pH = 1 angesäuert, auf 0 °C abgekühlt und 1 h weitergerührt wurde. Der entstandene Niederschlag wurde abgesaugt, zweimal mit je 25 ml Wasser nachgewaschen und getrocknet.

Das Rohprodukt wurde aus 40 ml Essigsäureethylester umkristallisiert und getrocknet Es wurden 7,42 g Trimethylbenzoylphenylphosphinsäure isoliert. Der Gehalt war nach HPLC > 98%.

## Patentansprüche

1. Acyl- oder Bisacylphosphinderivat gemäß Formel (I) 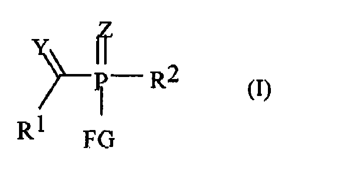 worin
R¹ Phenyl, Tolyl, Xylyl, α-Naphthyl, β-Naphthyl, 2- 3- oder 4-Chlorphenyl, 2,6- oder 2,4-Dichlorphenyl, 2,4,6-Trichlorphenyl, 2-, 3- oder 4-Methylphenyl, 2,6- oder 2,4-Dimethylphenyl, 2,4,6-Trimethylphenyl, 2-, 3- oder 4-Ethylphenyl, 2,6- oder 2,4-Diethylphenyl, 2-, 3- oder 4-*iso*-Propylphenyl, 2-, 3- oder 4-tert.-Butylphenyl, 2-, 3- oder 4-Methoxyphenyl, 2,6- oder 2,4-Dimethoxyphenyl, 2,6- oder 2,4-Diethoxyphenyl, Methylnaphthyl, 2,6-Dimethylphenyl, 2,4,6-Trimethylphenyl, 2,6-Dimethoxyphenyl, 2,6-Dichlorphenyl, 4-Bromphenyl, 2- oder 4-Nitrophenyl, 2,4- oder 2,6-Dinitrophenyl, 4-Dimethylaminophenyl, 4-Acetylphenyl, Cyclopentyl, Cyclohexyl, 2,5-Dimethylcyclopentyl, 2,6-Dimethylcyclohexyl, 2,6-Diethylcyclohexyl, 2,6-Dimethoxycyclohexyl, 2,6-Diethoxycyclohexyl, 2,6-Dichlorcyclohexyl, 2,5-Dichlorcyclopentyl, 2- oder 3-Furyl, 2- oder 3-Thiophenyl, 2- oder3-Pyrryl, Dimethylpyrryl oder ortho-substituierte Phenyle, wie 2-Methylphenyl, 2-Methoxyphenyl oder 2-Chlorphenyl ist,
R³, R⁵, R⁶, R⁷, C₁ - C₁₈-Alkyl, gegebenenfalls durch ein oder mehrere Sauerstoff- und/oder schwefelatome und/oder ein oder mehrere substituierte oder unsubstituierte Iminogruppen unterbrochenes C₂-C₁₈-Alkyl, C₂-C₁₈-Alkenyl, C₆-C₁₂-Aryl, C₅-C₁₂-Cycloalkyl oder einen fünf- bis sechsgliedrigen, Sauerstoff-, Stickstoff- und/oder Schwefelatome aufweisenden Heterocyclus, wobei die genannten Reste jeweils durch Aryl, Alkyl, Axyloxy, Alkyloxy, Heteroatome und/oder Heterocyclen substituiert sein können,
R² ferner gegebenenfalls durch Aryl, Alkyl, Aryloxy, Alkyloxy, Heteroatome und/oder Heterocyclen substituiertes C₁-C₁₈-Alkoxy oder R¹-(C=Y)-,
Y O, S, NR³, N-OR³ oder N-NR³R⁴,
Z O, S, NR³, N-OR³, N-NR³R⁴ oder ein freies Elektronenpaar,
R³ Wasserstoff, C₁ bis C₄-Alkyl, -SO₃H, Phenyl oder Acetyl,
R⁴ Wasserstoff, C₁ bis C₄-Alkyl, COOR³, Arylsulfonyl oder gegebenenfalls durch Aryl, Alkyl, Aryloxy, Alkyloxy, Heteroatome und/oder Heterocyclen substituiertes C₆-C₁₂-Aryl,
FG eine Abgangsgruppe der Struktur-Cl, -CN, -OCN, -SCN, -N⁺R⁶R⁷R⁸, -O(CO)R⁵, -O(CO)OR⁵, -O(SO)Cl, -O(SO₂)R⁵ oder -O(CO)Cl,
R⁵ ferner gegebenenfalls durch Aryl, Alkyl, Aryloxy, Alkyloxy, Heteroatome und/oder Heterocyclen substituiertes C₁-C₁₈-Alkoxy, sowie
R° gegebenenfalls durch Aryl, Alkyl, Aryloxy, Alkyloxy, Heteroatome und/oder Heterocyclen substituiertes C₁-C₁₈-Alkyl oder gegebenenfalls durch ein oder mehrere Sauerstoff- und/oder Schwefelatome und/oder ein oder mehrere substituierte oder unsubstituierte Iminogruppen unterbrochenes C₂ - C₁₈-Alkyl,
bedeuten.

2. Acyl- oder Bisacylphosphinderivat nach Anspruch 1, worin
Y O, S oder NR³,
Z O, S, NR³ oder ein freies Elektronenpaar,
FG -Cl, -O(CO)R⁵, -O(CO)OR⁵, -O(SO)Cl, -O(SO₂)R⁵ oder -O(CO)Cl
bedeuten.

3. Acyl- oder Bisacylphosphinderivat nach Anspruch 1, worin
Y O oder S,
Z 0, S oder ein freies Elektronenpaar,
FG -Cl, -O(CO)R⁵, -O(CO)OR⁵ oder -O(SO₂)R⁵
bedeuten.

4. Acyl- oder Bisacylphosphinderivat nach Anspruch 1, worin
Y O,
Z 0 oder ein freies Elektronenpaar,
FG -Cl oder -O(SO₂)R⁵
bedeuten.

5. Acyl- oder Bisacylphosphinderivat gemäß einem der Ansprüche 1 bis 4, worin
R¹ 2,4,6-Trimethylphenyl, 2,6-Dimethylphenyl, 2,6-Dimethoxyphenyl, 2,6-Dichlorphenyl, 2,4,6-Trichlorphenyl oder Phenyl und
R² Phenyl oder Ethoxy
bedeuten.

6. verfahren zur Herstellung eines Acyl- oder Bisacylphosphinderivates der Formel (I), 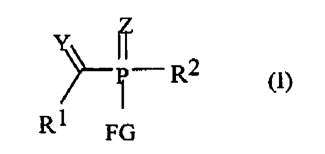 worin
R¹ Phenyl, Tolyl, Xylyl, α-Naphthyl, β-Naphthyl, 2- 3- oder 4-Chlorphenyl, 2,6-oder2,4-Dichlorphenyl, 2,4,6-Trichlorphenyl, 2-, 3- oder 4-Methylphenyl, 2,6- oder 2,4-Dimethylphenyl, 2.4,6-Trimethylphenyl, 2-, 3- oder 4-Ethylphenyl, 2,6- oder 2,4-Diethylphenyl, 2-, 3- oder 4-*iso*-Propylphenyl, 2-, 3- oder 4-tert.-Butylphenyl, 2-, 3- oder 4-Methoxyphenyl, 2,6- oder 2,4-Dimethoxyphenyl, 2,6- oder 2,4-Diethoxyphenyl, Methylnaphthyl, 2,6-Dimethylphenyl, 2,4,6-Trimethylphenyl, 2,6-Dimethoxyphenyl, 2,6-Dichlorphenyl, 4-Bromphenyl, 2- oder 4-Nitrophenyl, 2,4- oder 2,6-Dinitrophenyl, 4-Dimethylaminophenyl, 4-Acetylphenyl, Cyclopentyl, Cyclohexyl, 2,5-Dimethylcyclopentyl, 2,6-Dimethylcyclohexyl, 2,6-Diethylcyclohexyl, 2,6-Dimethoxycyclohexyl, 2,6-Diethoxycyclohexyl, 2,6-Dichlorcyclohexyl, 2,5-Dichlorcyclopentyl, 2- oder 3-Furyl, 2- oder 3-Thiophenyl, 2- oder 3-Pyrryl, Dimethylpyrryl oder ortho-substituierte Phenyle, wie 2-Methylphenyl, 2-Methoxyphenyl oder 2-Chlorphenyl ist, ¹
R², R⁵, R⁶, R⁷, C₁-C₁₈-Alkyl, gegebenenfalls durch ein oder mehrere Sauerstoff- und/oder Schwefelatome und/oder ein oder mehrere substituierte oder unsubstituierte Iminogruppen unterbrochenes C₂-C₁₈-Alkyl, C₂-C1₈-Alkenyl, C₆-C₁₂-Aryl, C₅-C₁₂-Cycloalkyl oder einen fünf- bis sechsgliedrigen, Sauerstoff-, Stickstoff- und/oder Schwefelatome aufweisenden Heterocyclus, wobei die genannten Reste jeweils durch Aryl, Alkyl, Aryloxy, Alkyloxy, Heteroatome und/oder Heterocyclen substituiert sein können,
R² ferner gegebenenfalls durch Aryl, Alkyl, Aryloxy, Alkyloxy, Heteroatome und/oder Heterocyclen substituiertes C₁-C₁₈-Alkoxy oder R¹-(C=Y)-,
Y 0, S, NR³, N-OR³ oder N-NR³R⁴,
Z O, S, NR³, N-OR³, N-NR³R⁴ oder ein freies Elektronenpaar,
R³ Wasserstoff, C₁ bis C₄-Alkyl, -SO₃H, Phenyl oder Acetyl,
R⁴ Wasserstoff, C₁ bis C₄-Alkyl, COOR³, Arylsulfonyl oder gegebenenfalls durch Aryl, Alkyl, Aryloxy, Alkyloxy, Heteroatome und/oder Heterocyclen substituiertes C₆-C₁₂-Aryl,
FG eine Abgangsgruppe der Struktur-Cl, -CN, -OCN, -SCN, -N⁺R⁶R⁷R⁸, -O(CO)R⁵, -O(CO)OR⁵, -O(SO)Cl, -O(SO₂)R⁵ oder -O(CO)Cl,
R⁵ ferner gegebenenfalls durch Aryl, Alkyl, Aryloxy, Alkyloxy, Heteroatome und/oder Heterocyclen substituiertes C₁-C₁₈-Alkoxy, sowie
R⁸ gegebenenfalls durch Aryl, Alkyl, Aryloxy, Alkyloxy, Heteroatome und/oder Heterocyclen substituiertes C₁-C₁₈-Alkyl oder gegebenenfalls durch ein oder mehrere Sauerstoff- und/oder Schwefelatome und/oder ein oder mehrere substituierte oder unsubstituierte Iminogruppen unterbrochenes C₂ -C₁₈-Alkyl, bedeuten aus einem Stoff der Formel (II), 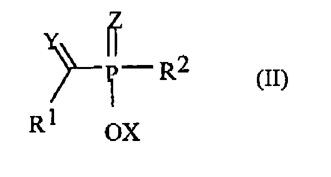
worin
X wasserstoff oder ein Kation ist,
**dadurch gekennzeichnet, daß** man Stoff (II) mit mindestens einem Mittel umsetzt, das die Gruppe -OX in eine Gruppe -FG überführt.

7. Verfahren nach Anspruch 6, **dadurch gekennzeichnet, daß** man Stoff (II) mit Phosgen (COCl₂) Thionylchlorid (SOCl₂) oder Sulfurylchlorid (SO₂Cl₂) umsetzt, um -OX in die Gruppe FG = -Cl zu überführen.

8. Verfahren nach Anspruch 6, **dadurch gekennzeichnet, daß** man Stoff (II) mit R⁵SO₂Cl, oder (R⁵SO₂)₂O umsetzt, um -OX in die Gruppe FG = -OSO₂R⁵ zu überführen.

9. Verwendung eines Acyl- oder Bisacylphosphinderivates nach einem der Ansprüche 1 bis 5 als Photoinitiator.

10. Verwendung eines Acyl- oder Bisacylphosphinderivates der Formel (I'), das sich von Formel (I) gemäß Anspruch 6 durch die Gruppe FG unterscheidet und worin FG die folgende Bedeutung hat
FG -Br, -(NR³)-NR⁴R⁹, -(NR³)-OR⁹ oder -SR³ (für Z=S) und
R⁹ Wasserstoff oder C₁ bis C₄-Alkyl,
als Photoinitiator.

11. Photoinitiatorgemische, enthaltend ein mindestens Acyl- oder Bisacylphosphinderivat nach einem der Ansprüche 1 bis 5.

12. Strahlungshärtbare Masse, enthaltend mindestens ein Acyl- oder Bisacylphosphinderivat nach einem der Ansprüche 1 bis 5 oder Photoinitiatorgemische gemäß Anspruch 11.

13. Strahlungshärtbare Zusammensetzungen, erhältlich durch Umsetzung mindestens eines Acyl- oder Bisacylphosphinderivates nach einem der Ansprüche 1 bis 5 mit einer freie Hydroxy-, Amino-,
Monoalkylamino-, Monoarylamino- und/oder Mercaptogruppen enthaltenden Verbindung.

14. Strahlungshärtbare Zusammensetzungen gemäß Anspruch 13, **dadurch gekennzeichnet, daß** es sich bei der Verbindung um eine polymerisierbare Verbindung mit einem zahlenmittleren Molekulargewicht Mₙ unter 20000 handelt.

## Claims

1. An acyl- or bisacylphosphine derivative of the formula (I) 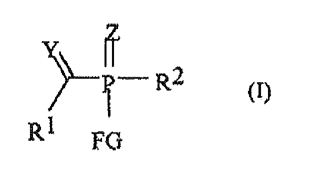 where
R¹ is phenyl, tolyl, xylyl, α-naphthyl, β-naphthyl, 2- 3- or 4-chlorophenyl, 2,6- or 2,4-dichlorophenyl, 2,4,6-trichlorophenyl, 2-, 3- or 4-methylphenyl, 2,6- or 2,4-dimethylphenyl, 2,4,6-trimethylphenyl, 2-, 3- or 4-ethylphenyl, 2,6- or 2,4-diethylphenyl, 2-, 3- or 4-*iso*-propylphenyl, 2-, 3- or 4-tert-butylphenyl, 2-, 3- or 4-methoxyphenyl, 2,6- or 2,4-dimethoxyphenyl, 2,6- or 2,4-diethoxyphenyl, methylnaphthyl, 2,6-dimethylphenyl, 2,4,6-trimethylphenyl, 2,6-dimethoxyphenyl, 2,6-dichlorophenyl, 4-bromophenyl, 2- or 4-nitrophenyl, 2,4- or 2,6-dinitrophenyl, 4-dimethylaminophenyl, 4-acetylphenyl, cyclopentyl, cyclohexyl, 2,5-dimethylcyclopentyl, 2,6-dimethylcyclohexyl, 2,6-diethylcyclohexyl, 2,6-dimethoxycyclohexyl, 2,6-diethoxycyclohexyl, 2,6-dichlorocyclohexyl, 2,5-dichlorocyclopentyl, 2- or 3-furyl, 2- or 3-thiophenyl, 2- or 3-pyrryl, dimethylpyrryl or ortho-substituted phenyls, such as 2-methylphenyl, 2-methoxyphenyl or 2-chlorophenyl,
R², R⁵, R⁶ and R⁷ are C₁ - C₁₈-alkyl, or C₂ - C₁₈-alkyl, C₂ - C₁₈-alkenyl, C₆ - C₁₂-aryl or C₅ - C₁₂-cycloalkyl, each of which is uninterrupted or interrupted by one or more oxygen and/or sulfur atoms and/or one or more substituted or unsubstituted imino groups, or are a five- to six-membered, oxygen, nitrogen and/or sulfur atom-containing heterocyclic radical, where the said radicals may each be substituted by aryl, alkyl, aryloxy, alkoxy, heteroatoms and/or heterocyclic radicals,
R² is furthermore C₁ - C₁₈-alkoxy, which is unsubstituted or substituted by aryl, alkyl, aryloxy, alkoxy, heteroatoms and/or heterocyclic radicals, or is R¹-(C=Y)-,
Y is 0, S, NR³, N-OR³ or N-NR³R⁴,
Z is 0, S, NR³, N-OR³, N-NR³R⁴ or a free pair of electrons,
R³ is hydrogen, C₁- to C₄-alkyl, -SO₃H, phenyl or acetyl,
R⁴ is hydrogen, C₁- to C₄-alkyl, COOR³ or arylsulfonyl, or C₆ - C₁₂-aryl which is unsubstituted or substituted by aryl, alkyl, aryloxy, alkoxy, heteroatoms and/or heterocyclic radicals,
FG is a leaving group having the structure -Cl, -CN, -OCN, -SCN, -N⁺R⁶R⁷R⁸, -O(CO)R⁵, -O(CO)OR⁵, -O(SO)Cl, -O(SO₂)R⁵ or -O(CO)Cl,
R⁵ is furthermore C₁ - C₁₈-alkoxy, which is unsubstituted or substituted by aryl, alkyl, aryloxy, alkoxy, heteroatoms and/or heterocyclic radicals, and
R⁸ is C₁ - C₁₈-alkyl, which is unsubstituted or substituted by aryl, alkyl, aryloxy, alkoxy, heteroatoms and/or heterocyclic radicals, or C₂ - C₁₈-alkyl, which is uninterrupted or interrupted by one or more oxygen and/or sulfur atoms and/or one or more substituted or unsubstituted imino groups.

2. An acyl- or bisacylphosphine derivative according to claim 1, where
Y is 0, S or NR³,
Z is 0, S, NR³ or a free pair of electrons,
FG is -Cl, -O(CO)R⁵, -O(CO)OR⁵, -O(SO)Cl, -O(SO₂)R⁵ or -O(CO)Cl.

3. An acyl- or bisacylphosphine derivative according to claim 1, where
Y is 0 or S,
Z is 0, S or a free pair of electrons,
FG is -Cl, -O(CO)R⁵, -O(CO)OR⁵ or -O(SO₂)R⁵.

4. An acyl- or bisacylphosphine derivative according to claim 1, where
Y is 0,
Z is 0 or a free pair of electrons,
FG is -Cl or -O(SO₂)R⁵.

5. An acyl- or bisacylphosphine derivative according to any one of claims 1 to 4, where
R¹ is 2,4,6-trimethylphenyl, 2,6-dimethylphenyl, 2,6-dimethoxyphenyl, 2,6-dichlorophenyl, 2,4,6- trichlorophenyl or phenyl, and
R² is phenyl or ethoxy.

6. A process for the preparation of an acyl- or bisacylphosphine derivative of the formula (I) 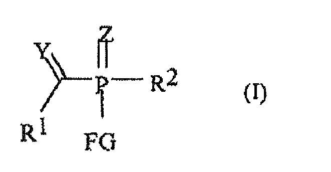 where
R¹ is phenyl, tolyl, xylyl, α-naphthyl, β-naphthyl, 2- 3- or 4-chlorophenyl, 2,6- or 2,4-dichlorophenyl, 2,4,6-trichlorophenyl, 2-, 3- or 4-methylphenyl, 2,6- or 2,4-dimethylphenyl, 2,4,6-trimethylphenyl, 2-, 3- or 4-ethylphenyl, 2,6- or 2,4-diethylphenyl, 2-, 3- or 4-*iso*-propylphenyl, 2-, 3- or 4-tert-butylphenyl, 2-, 3- or 4-methoxyphenyl, 2,6- or 2,4-dimethoxyphenyl, 2,6-or 2,4-diethoxyphenyl, methylnaphthyl, 2,6-dimethylphenyl, 2,4,6-trimethylphenyl, 2,6-dimethoxyphenyl, 2,6-dichlorophenyl, 4-bromophenyl, 2- or 4-nitrophenyl, 2,4- or 2,6-dinitrophenyl, 4-dimethylaminophenyl, 4-acetylphenyl, cyclopentyl, cyclohexyl, 2,5-dimethylcyclopentyl, 2,6-dimethylcyclohexyl, 2,6-diethylcyclohexyl, 2,6-dimethoxycyclohexyl, 2,6-diethoxycyclohexyl, 2,6-dichlorocyclohexyl, 2,5-dichlorocyclopentyl, 2- or 3-furyl, 2- or 3-thiophenyl, 2- or 3-pyrryl, dimethylpyrryl or ortho-substituted phenyls, such as 2-methylphenyl, 2-methoxyphenyl or 2-chlorophenyl,
R², R⁵, R⁶ and R⁷ are C₁ - C₁₈-alkyl, or C₂ - C₁₈-alkyl, C₂ - C₁₈-alkenyl, C₆ - C₁₂-aryl or C₅ - C₁₂-cycloalkyl, each of which is uninterrupted or interrupted by one or more oxygen and/or sulfur atoms and/or one or more substituted or unsubstituted imino groups, or are a five- to six-membered, oxygen, nitrogen and/or sulfur atom-containing heterocyclic radical, where the said radicals may each be substituted by aryl, alkyl, aryloxy, alkoxy, heteroatoms and/or heterocyclic radicals,
R² is furthermore C₁ - C₁₈-alkoxy, which is unsubstituted or substituted by aryl, alkyl, aryloxy, alkoxy, heteroatoms and/or heterocyclic radicals, or is R¹-(C=Y)-,
Y is O, S, NR³, N-OR³ or N-NR³R⁴,
Z is 0, S, NR³, N-OR³, N-NR³R⁴ or a free pair of electrons,
R³ is hydrogen, C₁- to C₄-alkyl, -SO₃H, phenyl or acetyl,
R⁴ is hydrogen, C₁- to C₄-alkyl, COOR³ or arylsulfonyl, or C₆ - C₁₂-aryl which is unsubstituted or substituted by aryl, alkyl, aryloxy, alkoxy, heteroatoms and/or heterocyclic radicals,
FG is a leaving group having the structure -Cl, -CN, -OCN, -SCN, -N⁺R⁶R⁷R⁸, -O(CO)R⁵, -O(CO)OR⁵, -O(SO)Cl, -O(SO₂)R⁵ or -O(CO)Cl,
R⁵ is furthermore C₁ - C₁₈-alkoxy, which is unsubstituted or substituted by aryl, alkyl, aryloxy, alkoxy, heteroatoms and/or heterocyclic radicals, and
R⁸ is C₁ - C₁₈-alkyl, which is unsubstituted or substituted by aryl, alkyl, aryloxy, alkoxy, heteroatoms and/or heterocyclic radicals, or C₂ - C₁₈-alkyl, which is uninterrupted or interrupted by one or more oxygen and/or sulfur atoms and/or one or more substituted or unsubstituted imino groups, froma substance of the formula (II) 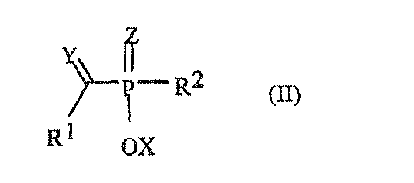
where
X is hydrogen or a cation,
which comprises reacting substance (II) with at least one agent which converts the -OX group into an -FG group.

7. The process according to claim 6, wherein substance (II) is reacted with phosgene (COCl₂), thionyl chloride (SOCl₂) or sulfuryl chloride (SO₂Cl₂) in order to convert -OX into the group FG = -Cl.

8. The process according to claim 6, wherein substance (II) is reacted with R⁵SO₂Cl or (R⁵SO₂)₂O in order to convert -OX into the group FG = - OSO₂R⁵.

9. The use of an acyl- or bisacylphosphine derivative according to any one of claims 1 to 5 as photoinitiator.

10. The use of a formula (I') acyl- or bisacylphosphine derivative which differs from the formula (I) of claim 6 in the FG group and where FG is defined as follows:
FG is -Br, -(NR³)-NR⁴R⁹, -(NR³)-OR⁹ or -SR³ (for Z=S), and
R⁹ is hydrogen or C₁- to C₄-alkyl,
as photoinitiator.

11. A photoinitiator mixture comprising at least one acyl- or bisacylphosphine derivative according to any one of claims 1 to 5.

12. A radiation-curable composition comprising at least one acyl- or bisacylphosphine derivative according to any one of claims 1 to 5 or a photoinitiator mixture according to claim 11.

13. A radiation-curable composition obtainable by reaction of at least one acyl- or bisacylphosphine derivative according to any one of claims 1 to 5 with a compound containing free hydroxyl, amino, monoalkylamino, monoarylamino and/or mercapto groups.

14. A radiation-curable composition according to claim 13, wherein the compound is a polymerizable compound having a number average molecular weight Mₙ of less than 20,000.

## Revendications

1. Dérivé d'acylphosphine ou de bisacylphosphine selon la formule (I) 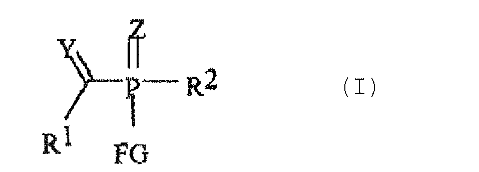 dans laquelle
R¹ est un groupe phényle, tolyle, xylyle, α-naphtyle, β-naphtyle, 2- 3- ou 4-chlorophényle, 2,6- ou 2,4-dichlorophényle, 2,4,6-trichlorophényle, 2-, 3- ou 4-méthylphényle, 2,6- ou 2,4-diméthylphényle, 2, 4, 6-triméthylphényle, 2-, 3- ou 4-éthylphényle, 2,6- ou 2,4-diéthylphényle, 2-, 3- ou 4-isopropylphényle, 2-, 3- ou 4-tert-butylphényle, 2-, 3- ou 4-méthoxyphényle, 2,6- ou 2,4-diméthoxyphényle, 2,6- ou 2,4-diéthoxyphényle, méthylnaphtyle, 2,6-diméthylphényle, 2,4,6-triméthylphényle, 2,6-diméthoxyphényle, 2,6-dichlorophényle, 4-bromophényle, 2- ou 4-nitrophényle, 2,4- ou 2,6-dinitrophényle, 4-diméthylaminophényle, 4-acétylphényle, cyclopentyle, cyclohexyle, 2,5-diméthylcyclopentyle, 2,6-diméthylcyclohexyle, 2,6-diéthylcyclohexyle, 2,6-diméthoxycyclohexyle, 2,6-diéthoxycyclohexyle, 2,6-dichlorocyclohexyle, 2,5-dichlorocyclopentyle, 2- ou 3-furyle, 2- ou 3-thiophényle, 2- ou 3-pyrryle, diméthylpyrryle ou des groupes phényle substitués en ortho, tels que 2-méthylphényle, 2-méthoxyphényle ou 2-chlorophényle,
R², R⁵, R⁶, R⁷ représentent un groupe alkyle en C₁-C₁₈, un groupe alkyle en C₂-C₁₈, alcényle en C₂-C₁₈, aryle en C₆-C₁₂, cycloalkyle en C₅-C₁₂, éventuellement interrompu par un ou plusieurs atomes d'oxygène et/ou de soufre et/ou un ou plusieurs groupes imino substitués ou non substitués, ou un hétérocycle à cinq ou six chaînons, comportant des atomes d'oxygène, d'azote et/ou de soufre, les radicaux nommés pouvant être substitués chacun par aryle, alkyle, aryloxy, alkyloxy, des hétéroatomes et/ou des hétérocycles,
R² représente en outre un groupe alcoxy en C₁-C₁₈ éventuellement substitué par aryle, alkyle, aryloxy, alkyloxy, des hétéroatomes et/ou des hétérocycles, ou R¹(C=Y)-,
Y représente 0, S, NR³, N-OR³ ou N-NR³R⁴,
Z représente 0, S, NR³, N-OR³, N-NR³R⁴ ou une paire d'électrons libres,
R³ représente un atome d'hydrogène, un groupe alkyle en C₁-C₄, -SO₃H, phényle ou acétyle,
R⁴ représente un atome d'hydrogène, un groupe alkyle en C₁-C₄, COOR³, arylsulfonyle ou un groupe aryle en C₆-C₁₂ éventuellement substitué par aryle, alkyle, aryloxy, alkyloxy, des hétéroatomes et/ou des hétérocycles,
FG représente un groupe partant de structure -Cl, -CN, -OCN, -SCN, -N⁺R⁶R⁷R⁸, -O(CO)R⁵, -O(CO)OR⁵, -O(SO)Cl, -O(SO₂)R⁵ ou -O(CO)Cl,
R⁵ représente en outre un groupe alcoxy en C₁-C₁₈ éventuellement substitué par aryle, alkyle, aryloxy, alkyloxy, des hétéroatomes et/ou des hétérocycles, et
R⁸ représente un groupe alkyle en C₁-C₁₈ éventuellement substitué par aryle, alkyle, aryloxy, alkyloxy, des hétéroatomes et/ou des hétérocycles ou un groupe alkyle en C₂-C₁₈ éventuellement interrompu par un ou plusieurs atomes d'oxygène et/ou de soufre et/ou un ou plusieurs groupes imino substitués ou non substitués.

2. Dérivé d'acylphosphine ou de bisacylphosphine selon la revendication 1, dans lequel
Y représente 0, S ou NR³,
Z représente 0, S, NR³ ou une paire d'électrons libres,
FG représente -Cl, -O(CO)R⁵, -O(CO)OR⁵, -O(SO)Cl, -O(SO₂)R⁵ ou -O(CO)Cl.

3. Dérivé d'acylphosphine ou de bisacylphosphine selon la revendication 1, dans lequel
Y représente 0 ou S,
Z représente O, S ou une paire d'électrons libres,
FG représente -Cl, -O(CO)R⁵, -O(CO)OR⁵ ou -O(SO₂)R⁵.

4. Dérivé d'acylphosphine ou de bisacylphosphine selon la revendication 1, dans lequel
Y représente 0,
Z représente 0 ou une paire d'électrons libres,
FG représente -Cl ou -O(SO₂)R⁵.

5. Dérivé d'acylphosphine ou de bisacylphosphine selon les revendications 1 à 4, dans lequel
R¹ représente un groupe 2,4,6-triméthylphényle, 2,6-diméthylphényle, 2,6-dimethoxyphényle, 2,6-dichlorophényle, 2,4,6-trichlorophényle ou phényle et
R² représente un groupe phényle ou éthoxy.

6. Procédé pour la préparation d'un dérivé d'acylphosphine ou de bisacylphosphine de la formule (I) 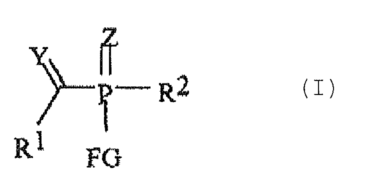 dans laquelle
R¹ est un groupe phényle, tolyle, xylyle, α-naphtyle, β-naphtyle, 2- 3- ou 4-chlorophényle, 2,6- ou 2,4-dichlorophényle, 2,4,6-trichlorophényle, 2-, 3- ou 4-méthylphényle, 2,6- ou 2,4-diméthylphényle, 2, 4, 6-triméthylphényle, 2-, 3- ou 4-éthylphényle, 2,6- ou 2,4-diéthylphényle, 2-, 3- ou 4-isopropylphényle, 2-, 3- ou 4-tert-butylphényle, 2-, 3- ou 4-méthoxyphényle, 2,6- ou 2,4-diméthoxyphényle, 2,6- ou 2,4-diéthoxyphényle, méthylnaphtyle, 2,6-diméthylphényle, 2,4,6-triméthylphényle, 2,6-diméthoxyphényle, 2,6-dichlorophényle, 4-bromophényle, 2- ou 4-nitrophényle, 2,4- ou 2,6-dinitrophényle, 4-diméthylaminophényle, 4-acétylphényle, cyclopentyle, cyclohexyle, 2,5-diméthylcyclopentyle, 2,6-diméthylcyclohexyle, 2,6-diéthylcyclohexyle, 2,6-diméthoxycyclohexyle, 2,6-diéthoxycyclohexyle, 2,6-dichlorocyclohexyle, 2,5-dichlorocyclopentyle, 2- ou 3-furyle, 2- ou 3-thiophényle, 2- ou 3-pyrryle, diméthylpyrryle ou des groupes phényle substitués en ortho, tels que 2-méthylphényle, 2-méthoxyphényle ou 2-chlorophényle,
R², R⁵, R⁶, R⁷ représentent un groupe alkyle en C₁-C_{18,} un groupe alkyle en C₂-C₁₈, alcényle en C₂-C₁₈, aryle en C₆-C₁₂, cycloalkyle en C₆-C₁₂ éventuellement interrompu par un ou plusieurs atomes d'oxygène et/ou de soufre et/ou un ou plusieurs groupes imino substitués ou non substitués, ou un hétérocycle à cinq ou six chaînons, comportant des atomes d'oxygène, d'azote et/ou de soufre, les radicaux nommés pouvant être substitués chacun par aryle, alkyle, aryloxy, alkyloxy, des hétéroatomes et/ou des hétérocycles,
R² représente en outre un groupe alcoxy en C₁-C₁₈ éventuellement substitué par aryle, alkyle, aryloxy, alkyloxy, des hétéroatomes et/ou des hétérocycles, ou R¹-(C=Y)-,
Y représente 0, S, NR³, N-OR³ ou N-NR³R⁴,
Z représente 0, S, NR³, N-OR³, N-NR³R⁴ ou une paire d'électrons libres,
R³ représente un atome d'hydrogène, un groupe alkyle en C₁-C₄, -SO₃H, phényle ou acétyle,
R⁴ représente un atome d'hydrogène, un groupe alkyle en C₁-C₄, COOR³, arylsulfonyle ou un groupe aryle en C₆-C₁₂ éventuellement substitué par aryle, alkyle, aryloxy, alkyloxy, des hétéroatomes et/ou des hétérocycles,
FG représente un groupe partant de structure -Cl, -CN, -OCN, -SCN, -N⁺R⁶R⁷R⁸, -O(CO)R⁵, -O(CO)OR⁵, -O(SO)Cl, -O(SO₂)R⁵ ou -O(CO)Cl,
R⁵ représente en outre un groupe alcoxy en C₁-C₁₈ éventuellement substitué par aryle, alkyle, aryloxy, alkyloxy, des hétéroatomes et/ou des hétérocycles, et
R⁸ représente un groupe alkyle en C₁-C₁₈ éventuellement substitué par aryle, alkyle, aryloxy, alkyloxy, des hétéroatomes et/ou des hétérocycles ou un groupe alkyle en C₂-C₁₈ éventuellement interrompu par un ou plusieurs atomes d'oxygène et/ou de soufre et/ou un ou plusieurs groupes imino substitués ou non substitués,
à partir d'une substance de formule (II), 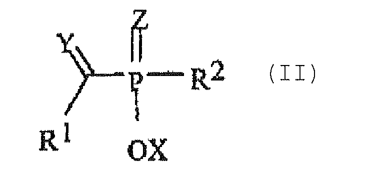 dans laquelle
X représente un atome d'hydrogène ou un cation,
**caractérisé en ce qu'**on fait réagir la substance (II) avec au moins un agent qui convertit le groupe -OX en un groupe -FG.

7. Procédé selon la revendication 6, **caractérisé en ce qu'**on fait réagir la substance (II) avec du phosgène (COCl₂), du chlorure de thionyle (SOCl₂) ou du chlorure de sulfuryle (SO₂Cl₂), pour convertir -OX en le groupe FG = -Cl.

8. Procédé selon la revendication 6, **caractérisé en ce qu'**on fait réagir la substance (II) avec R⁵SO₂Cl ou (R⁵SO₂)₂O, pour convertir -OX en le groupe FG = -OSO₂R⁵.

9. Utilisation d'un dérivé d'acylphosphine ou de bisacylphosphine selon l'une quelconque des revendications 1 à 5 en tant que photoamorceur.

10. Utilisation d'un dérivé d'acylphosphine ou de bisacylphosphine de formule (I'), qui diffère de la formule (I) selon la revendication 6 par le groupe FG et dans laquelle FG a la signification suivante
FG représente -Br, -(NR³)-NR⁴R⁹, -(NR³)-OR⁹ ou -SR³ (pour Z = S) et
R⁹ représente un atome d'hydrogène ou un groupe alkyle en C₁-C₄,
en tant que photoamorceur.

11. Mélanges de photoamorceurs, contenant au moins un dérivé d'acylphosphine ou de bisacylphosphine selon l'une quelconque des revendications 1 à 5.

12. Matière durcissable par irradiation, contenant au moins un dérivé d'acylphosphine ou de bisacylphosphine selon l'une quelconque des revendications 1 à 5 ou des mélanges de photoamorceurs selon la revendication 11.

13. Compositions durcissables par irradiation, pouvant être obtenues par mise en réaction d'au moins un dérivé d'acylphosphine ou de bisacylphosphine selon l'une quelconque des revendications 1 à 5 avec un composé contenant un groupe hydroxy, amino, monoalkylamino, monoarylamino et/ou mercapto libre.

14. Compositions durcissables par irradiation selon la revendication 13, **caractérisées en ce que** le composé consiste en un composé polymérisable ayant une masse moléculaire moyenne en nombre Mₙ inférieure à 20 000.
